# EUROPEAN PATENT SPECIFICATION

(11) **EP 4 113 293 B1**
(45) Date of publication and mention of the grant of the patent: **12.02.2025**
(21) Application number: 22175936.8
(22) Date of filing: 27.05.2022
(51) Int. Cl.: G06F 9/451, G05B 19/418, G06F 11/36, G06F 11/32, G06F 8/34

(54) **SIMULATION SYSTEM, METHOD FOR SIMULATION SYSTEM, AND SIMULATION PROGRAM**
SIMULATIONSSYSTEM, VERFAHREN FÜR EIN SIMULATIONSSYSTEM UND SIMULATIONSPROGRAMM
SYSTÈME DE SIMULATION, PROCÉDÉ POUR SYSTÈME DE SIMULATION, ET PROGRAMME DE SIMULATION

(30) Priority: 30.06.2021 JP 2021108836
(43) Date of publication of application: 04.01.2023
(73) Proprietor: OMRON Corporation, Kyoto-shi, Kyoto 600-8530 (JP)
(72) Inventor: IWAMURA, Shintaro, Kyoto-shi, 600-8530 (JP); OHNUKI, Haruna, Kyoto-shi, 600-8530 (JP)
(74) Representative: Mewburn Ellis LLP

(56) References cited:
- CN-A- 111 797 521
- TECHNOCRATS: "Mitsubishi Robot 3D Simulation Part2", 26 June 2019 (2019-06-26), XP055977786, Retrieved from the Internet <URL:https://www.youtube.com/watch?v=A_UeFC2rncg> [retrieved on 20221104]
- TECHNOCRATS: "Mitsubishi Robot 3D Simulation Part2", 26 June 2019 (2019-06-26), XP055977789, Retrieved from the Internet <URL:https://www.youtube.com/watch?v=A_UeFC2rncg> [retrieved on 20221104]
- PRÄHOFER H ET AL: "Deterministic Replay Debugging of IEC 61131-3 SoftPLC Programs", 2010 8TH IEEE INTERNATIONAL CONFERENCE ON INDUSTRIAL INFORMATICS (INDIN 2010) - 13-16 JULY 2010 - OSAKA, JAPAN, IEEE, PISCATAWAY, NJ, USA, 13 July 2010 (2010-07-13), pages 1110 - 1117, XP002625458, ISBN: 978-1-4244-7300-7, DOI: 10.1109/INDIN.2010.5549586

## Description

### BACKGROUND OF THE INVENTION

### Field of the Invention

The present disclosure relates to a simulation system, more particularly to a program debugging feature.

### Description of the Background Art

Computer-assisted simulations have been applied to various technical fields. Such simulations may be a great help for preliminary discussions and considerations of devices and apparatuses even before they are ready to be used.

Japanese Patent Laying-Open No. 2021-045797 describes an apparatus usable for the simulations. This apparatus is provided with a first behavior calculator and a second behavior calculator. The first behavior calculator calculates the behavior of a first target disposed in a virtual space that corresponds to a first device mounted with an accessory device. The second behavior calculator calculates the behavior of a second target disposed in a virtual space that corresponds to a second device mounted with an accessory device. It is further described in this literature that, for each one of predetermined time steps, the first behavior calculator calculates the behavior of the first target corresponding to the first device mounted with the accessory device in the relevant time step, and the second behavior calculator calculates the behavior of the accessory device mounted on the first device on the basis of the calculated behavior of the first target (refer to the "Abstract").

The video entitled "Mitsubishi Robot 3D Simulation Part2" by Technocrats (URL: https://www.youtube.com/watch?v=A_UeFC ADD2rneg), 26 June 2019 (2019-06-26), shows a development environment for a program controlling a robot.

Research paper "Deterministic Replay Debugging of IEC 61131-3 SoftPLC Programs" by Prahofer H et al, 2010 8TH IEEE INTERNATIONAL CONFERENCE ON INDUSTRIAL INFORMATICS (INDIN 2010) - 18-16 JULY 2010 , pages 1110-1117, DOI: 10.1109/INDIN.2010.5549586, ISBN: 978-1-4244-7300-7, relates to finding field failures in application runs.

CN111797521A discloses a three-dimensional simulation debugging and monitoring method for an automatic production line.

### SUMMARY OF THE INVENTION

The technique described in Japanese Patent Laying-Open No. 2021-045797, may demand that the simulations be repeatedly reproduced in order to verify the programs to operate the devices. This apparatus, therefore, may often require a great deal of time for the program verification. Thus, a simulation technique that allows the program verification to be more efficiently performed is required.

The present disclosure has been made in view of the above background, and an object in an aspect is to provide a simulation technique that allows the program verification to be more efficiently performed.

In an embodiment of this disclosure, a simulation system is provided according to claim 1.

As disclosed herein, the simulation system can display, for each step of the program, the 3D space for display of the position of the one or more devices in the 3D space and the value of the one or more variables referred to by the program. This may allow a user to easily debug the program by checking both the displays of the 3D space and the value of the one or more variables.

In the simulation system disclosed herein, the simulation screen further includes a user interface (UI) for input use configured to receive an operation input for reproduction or reverse reproduction of a simulation scene for each step of the program.

As disclosed herein, the simulation system can receive the operation input for reproduction or reverse reproduction of the simulation scene. This may allow a user to easily check before and after any problematic simulation scene through a reproduction or reverse reproduction feature.

In the simulation system disclosed herein, the UI for input use is configured to receive an operation input for stoppage or frame-by-frame reproduction of the simulation scene for each step of the program.

As disclosed herein, the simulation system can receive the operation input for the stoppage or frame-by-frame reproduction of the simulation scene. Thus, a user can look closely into details of the problematic simulation scene and the variable value through a stoppage or frame-by-frame reproduction feature.

In the simulation system disclosed herein, the UI for input use is configured to receive an operation input for reproduction or reverse reproduction of the simulation scene for one cycle or for one step of the program.

As disclosed herein, the simulation system can receive the operation input for reproduction or reverse reproduction of the simulation scene for one cycle or for one step of the program.

In the simulation system disclosed herein, the simulation screen is configured to receive an operation input for setting a breakpoint in the program.

As disclosed herein, the simulation system can receive the operation input for setting the breakpoint in the program.

In the simulation system disclosed herein, the UI for input use is configured to receive an operation input for slow reproduction or slow reverse reproduction of the simulation scene.

As disclosed herein, the simulation system can receive the operation input for slow reproduction or slow reverse reproduction of the simulation scene.

In the simulation system disclosed herein, the simulation screen further includes value-related information of the position of the one or more devices, and the simulation screen is configured to update the value-related information of the position of the one or more devices for each step of the program.

As disclosed herein, the simulation system may display the value-related information of the position of the one or more devices for each step of the program.

In the simulation system disclosed herein, the simulation screen is configured to further display the program. A display of the program includes a code of the program, and the value of the one or more variables. The simulation screen is configured to update the value of the one or more variables included in the display of the program for each step of the program.

As disclosed herein, the simulation system may display the program with the value-assigned variable(s). This may allow a user to debug the program by checking the display of the program for each step.

In the simulation system disclosed herein, the simulation screen is configured to highlight and display a changed value or a variable name to which the changed value has been assigned in a case of any change of the value of the one or more variables included in the display of the program when the step of the program proceeds or returns.

As disclosed herein, the simulation system can highlight and display any value-changed variable for a user.

In the simulation system disclosed herein, the display of the program is configured to select the value of one or more variables. The simulation screen is configured to display a graph including the variable selected from the display of the program.

As disclosed herein, the simulation system may display the graph including the selected variable.

In the simulation system disclosed herein, the display of the program is configured to highlight and display the variable included in the graph.

As disclosed herein, the simulation system may highlight and display the variable included in the currently displayed graph of the program.

In the simulation system disclosed herein, the simulation screen is configured to further display a flowchart of the program. A display of the flowchart is configured to highlight and display a block currently executed among one or more blocks included in the flowchart.

As disclosed herein, the simulation system can highlight and display the block currently executed among one or more blocks included in the flowchart. This may allow a user to easily identify the block currently executed.

In the simulation system disclosed herein, the display of the flowchart is configured to select one of the one or more blocks included in the flowchart. The display of the program is configured to display a program organization unit (POU) corresponding to the block that has been selected, or to highlight and display the POU.

As disclosed herein, the simulation system may display or highlight and display the POU corresponding to the block that has been selected. This may allow a user to easily check the POU corresponding to any desired block in the flowchart.

In another embodiment of this disclosure, a method executable by a simulation system is provided according to claim 14.

As disclosed herein, the method executable by the simulation system can display, for each step of the program, the 3D space for display of the position of the one or more devices in the 3D space, and the value of one or more variables referred to by the program. This may allow a user to easily debug the program by checking both the displays of the 3D space and the value of the one or more variables.

In yet another embodiment of this disclosure, a program is provided according to claim 15.

As disclosed herein, the program can cause the one or the plurality of processors to execute the above method.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a diagram illustrating an example of a device whose operation can be simulated by a simulation system according to an embodiment.
Fig. 2 is a diagram illustrating an example of simulation being executed by a simulation system 500.
Fig. 3 is a diagram illustrating an example of a unit configuration of a control system 2 including devices to which a simulation technique according to the embodiment is applicable.
Fig. 4 is a diagram illustrating an example of a hardware configuration of a device 100.
Fig. 5 is a diagram illustrating an example of functional configurations of simulation system 500.
Fig. 6 is a diagram illustrating a first example of ongoing simulation.
Fig. 7 is a diagram illustrating a second example of ongoing simulation.
Fig. 8 is a diagram illustrating a third example of ongoing simulation.
Fig. 9 is a diagram illustrating a first example of data stored in a repository 570.
Fig. 10 is a diagram illustrating a second example of data stored in repository 570.
Fig. 11 is a diagram illustrating a first example of a debug screen in simulation system 500.
Fig. 12 is a diagram illustrating a second example of the debug screen in simulation system 500.
Fig. 13 is a diagram illustrating a third example of the debug screen in simulation system 500.
Fig. 14 is a diagram illustrating a fourth example of the debug screen in simulation system 500.
Fig. 15 is a flowchart illustrating an example of a simulation recording process by simulation system 500.
Fig. 16 is a flowchart illustrating an example of a debugging process by simulation system 500.
Fig. 17 is a flowchart illustrating an example of a comparison process for between a program simulation result by simulation system 500 and a program execution result in a real environment.

### DESCRIPTION OF THE PREFERRED EMBODIMENTS

Embodiments of the technical idea according to the present disclosure are hereinafter described with reference to the accompanying drawings. In the description below, like components are illustrated with the same reference signs. Also, they are referred to likewise and have similar functional features. Such components, therefore, will not be repeatedly described in detail.

### <A. Example of application>

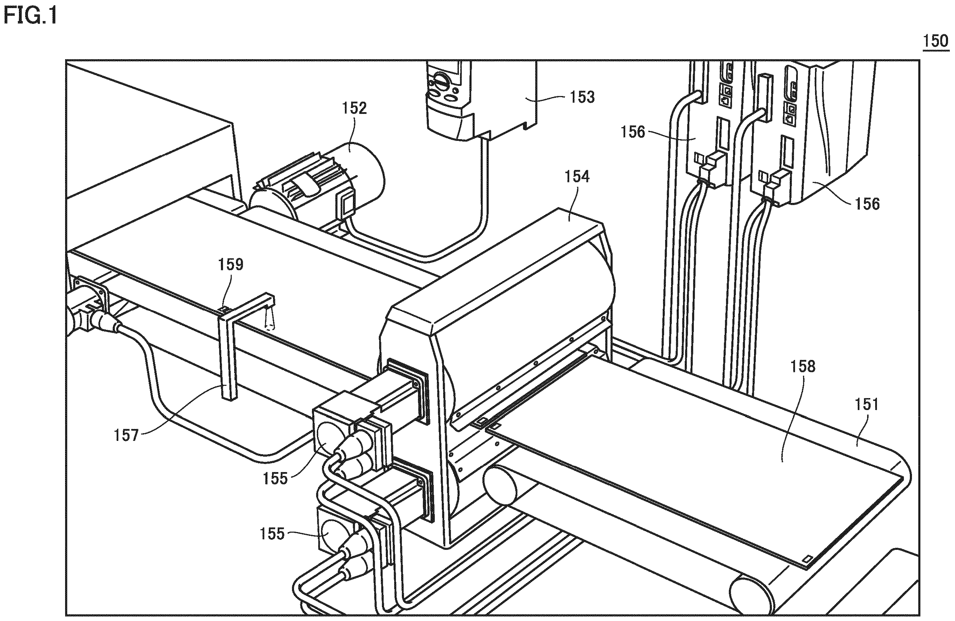

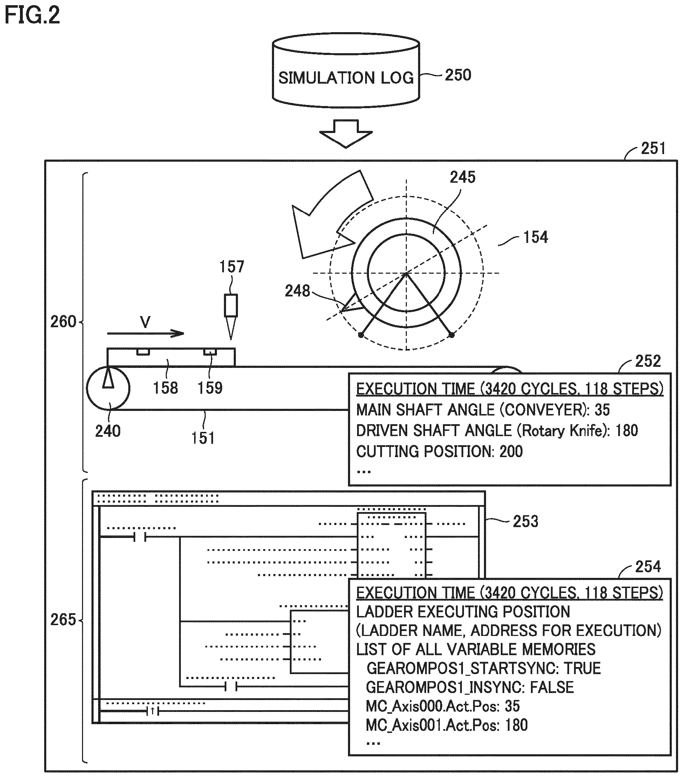

An exemplified scene to which the present invention is applied is described referring to Figs. 1 and 2.

### (a. Device targeted for simulation)

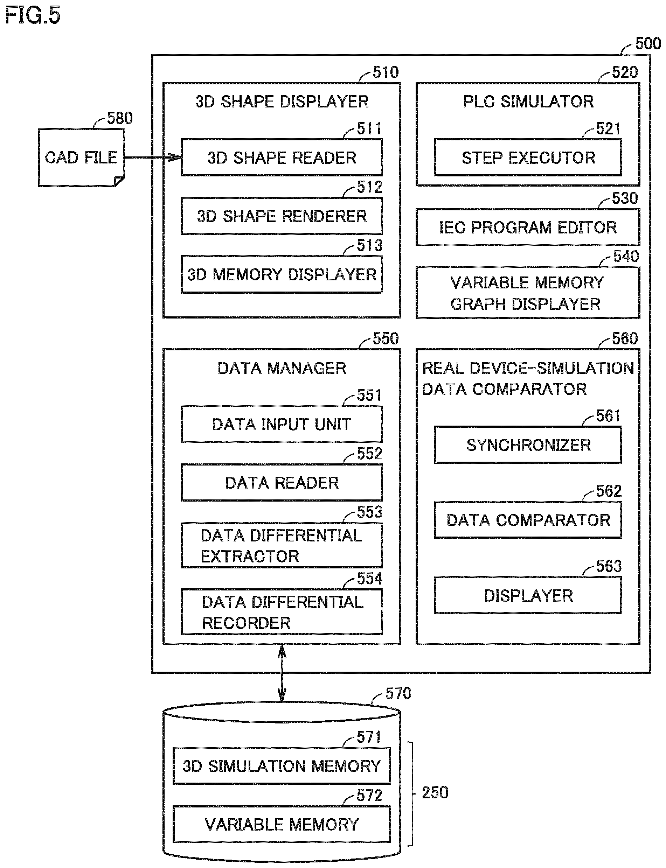

Fig. 1 is a diagram illustrating an example of a device whose operation can be simulated by a simulation system according to an embodiment. A simulation system 500 according to this embodiment (see Fig. 5) may simulate the operation of an optional device used in factory automation (FA) in plants and the like. Simulation system 500 may simulate the operation of robot arms, belt conveyers, rotary knives, sensors and any other optional device(s), and the operations of combinations of these.

A device 150 illustrated in Fig. 1 is a multifunction device including a conveyer 151 and a rotary knife 154. Device 150 has a cutting feature that allows a sheet 158 carried on conveyer 151 to be cut in a predetermined length. Device 150 includes the following components; conveyer 151, a motor 152, a motor controller 153, rotary knife 154, a motor 155, a motor controller 156, and a sensor 157.

Conveyer 151 transports sheet 158. Motor 152 is connected to a main shaft serving to rotate the conveyer and drives conveyer 151. Motor controller 153 controls the speed or torque of motor 152.

Rotary knife 154 includes a rotatable roller and a knife attached onto this roller. As a result of the roller being rotated, the knife cuts sheet 158 carried on conveyer 151. Motor 155 is connected to the roller of rotary knife 154 and drives rotary knife 154. Motor controller 156 controls the speed or torque of motor 155.

Sensor 157 detects a cutting position 159 on sheet 158. Rotary knife 154 cuts the sheet at cutting position 159 detected by sensor 157.

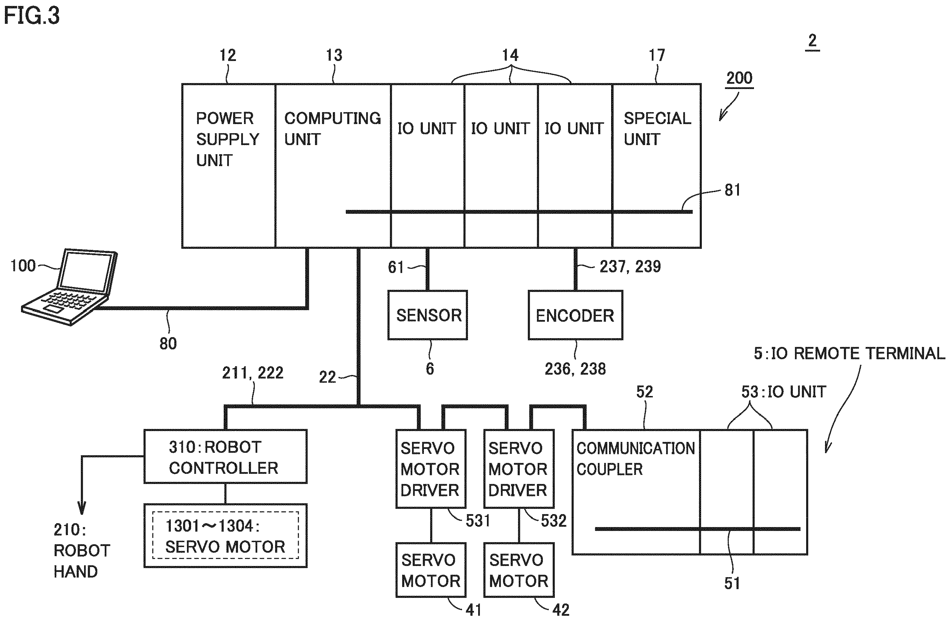

Motor controllers 153 and 156 and sensor 157 may be connected to a programmable logic controller (PLC) 200 (see Fig. 3). In this case, PLC 200 may read a signal from sensor 157 and control rotary knife 154 based on the read signal. PLC 200 controls device 150 on the basis of a program installed therein.

Simulation system 500 reproduces, in an ongoing simulation, the operation of program-installed PLC 200 and the operation of device 150 controlled by PLC 200. Thus, a user may debug the program of the PLC by checking the operation of device 150 in the simulation. In an aspect, the program that can be simulated by simulation system 500 may be an IEC program. The IEC program is a program that conforms to the IEC 61131-3 standards. This program includes a ladder program, structured text (ST), and the like.

### (b. Functional features of simulation system)

Fig. 2 is a diagram illustrating an example of simulation being executed by simulation system 500. Referring to Fig 2, functional features of simulation system 500 are hereinafter described. Simulation system 500 includes a simulation recording feature and a program debugging feature using a recorded simulation result. The description is given below to the features of simulation system 500 using device 150 as an example.

### (b-1. Simulation recording feature)

First, the simulation recording feature is described. Simulation system 500 reproduces, in a simulation using a 3D space, the operation of program-installed PLC 200 and the operation of device 150 controlled by PLC 200.

At the time, simulation system 500 records a simulation log 250. Simulation log 250 contains positional information 252 of an object in the 3D space for each execution time (or execution timing) of the program, and also contains a variable value 254 of the program for each execution time. The object described herein in the 3D space may include, for example, a device in the 3D space, a component(s) constituting the device, a work, any other optional object(s), and a combination(s) of these items.

In an aspect, the execution time (or execution timing) may be defined by the number of command steps of the program and the number of times when the program is repeatedly executed (cycles). The step may refer to one command of the program or commands in one row of the program entered in the editor (one command of the ladder program, commands in one row of ST entered in the editor, or the like). When one command or commands in one row of the program (one command of the ladder program, commands in one row of ST entered in the editor, or the like) has been executed, the program may be regarded as having proceeded by one step. Intervals between the steps may be determined by the command cycles of PLC 200. An example is given below, in which the program contains commands for 10 steps. In this case, the program has been executed once (one cycle) at a point of time when execution of the commands for 10 steps is completed, and the program has been repeatedly executed 10 times (cycles) at a point of time when execution of the commands for 100 steps is completed. In another aspect, the execution time (or execution timing) may be defined by an optional time interval (one second, 100 milliseconds, or the like) determined beforehand.

In the example illustrated in Fig. 2, simulation system 500 records positional information 252 of the object in the 3D space and variable value 254 of the program at a certain execution time (3420 cycles, 118 steps) as simulation log 250 in a manner that they are associated with each other.

Positional information 252 of the object in the 3D space contains the positional information of each of one or more objects present in the 3D space. In the example illustrated in Fig. 2, positional information 252 of the object in the 3D space may contain the angle of a main shaft 240 (shaft of the conveyer connected to motor 152), the angle of a driven shaft 245 (roller of rotary knife 154), a cutting position 248 (blade position), and positions of the other objects.

Variable value 254 of the program includes values of one or more variables referred to by a program 253 installed in PLC 200. In the example illustrated in Fig. 2, variable value 254 of the program includes values of GEAROMPOS1_STARTSYNC, GEAROMPOS1_INSYNC, MC_Axis000.Act.Pos, MC_Axis001.Act.Pos, and values of other variables.

### (b-2. Debugging feature)

Next, the debugging feature is described. On the basis of simulation log 250, simulation system 500 may reproduce the simulation and then display a simulation scene on a screen 251 for each step.

Screen 251 includes a display 260 of the 3D space, a display 265 of the program, positional information 252 of the object in the 3D space per execution time, and variable value 254 of the program per execution time.

Simulation system 500 includes a feature that reproduces or reversely reproduces the simulation while pausing the simulation for each step on the basis of an operation input from a user.

For example, a simulation scene is assumed represent a first execution time.

In this case, screen 251 presents display 260 of the 3D space, display 265 of the program, positional information 252 of the object in the 3D space, and variable value 254 of the program at the first execution time.

For example, the simulation scene is assumed to have proceeded (or returned) by one step from the first execution time to a second execution time based on an operation input from a user. In this case, screen 251 presents display 260 of the 3D space, display 265 of the program, positional information 252 of the object in the 3D space, and variable value 254 of the program at the second execution time. In an aspect, display 265 of the program may include a state of execution of the program to which variable value 254 of the program has been assigned.

By referring to screen 251, a user can check display 260 of the 3D space, display 265 of the program, positional information 252 of the object in the 3D space, and variable value 254 of the program at the same time. Therefore, the user may easily debug the program while checking the operation of device 150.

### <B. System configuration>

Next, referring to Figs. 3 to 5, the whole structural features of a system to be simulated by simulation system 500, hardware configurations of a device that operates as simulation system 500, and functional configurations of simulation system 500 are hereinafter described.

Fig. 3 is a diagram illustrating an example of a unit configuration of a control system 2 including devices to which a simulation technique according to this embodiment is applicable. Device 150 illustrated in Fig. 1 may be actualized as part of control system 2.

Control system 2 includes, for example, PLC 200, an IO remote terminal 5 and servo motor drivers 531 and 532 that are connected to PLC 200 through a field network 22, a robot controller 310, and IO devices disposed in the field (a sensor 6, encoders 236, 238, and the like).

PLC 200 includes a computing unit 13 that executes main computing processes, one or more IO units 14, and a special unit 17. These units are configured to transmit and receive data to and from one another through a system bus 81 and receive power supply from a power supply unit 12. A device 100 for simulation use is connectable to computing unit 13.

Device 100 may operate as simulation system 500. Device 100 may install, in computing unit 13, a program whose operation has been verified by the simulation. Computing unit 13 may control each device in control system 2 on the basis of the installed program. Device 100 may be connected to computing unit 13 through a network 80.

IO unit 14 collects detected values 61, 237 and 239 from the IO devices including sensor 6 and encoders 236 and 238. For example, sensor 6 may be sensor 157 that detects cutting position 159 of sheet 158 illustrated in Fig. 1. Encoders 236 and 238 may be attached to motor 152 that drives conveyer 151 or motor 155 that drives rotary knife 154. The detected values from the IO devices is set (written in) to corresponding bits of a memory of IO unit 14.

Computing unit 13 executes computations of the control program using values collected by IO unit 14 and sets (writes in) values of an obtained result to corresponding bits in IO unit 14. A peripheral device(s) or the IO devices are operated with reference to the bit values in IO unit 14. Thus, PLC 200 can control robot, conveyer, or the like, which are to be controlled, by transmitting and receiving data to and from the IO devices and the peripheral device(s) through IO unit 14.

Special unit 17 has features unsupported by IO unit 14, including input and output of analog data, temperature control, communication through a particular communication system.

For example, robot controller 310, servo motor drivers 531 and 532, IO remote terminal 5, and the like may be connected to field network 22.

As with IO unit 14, IO remote terminal 5 basically carries out typical processes associated with inputs and outputs. Specifically, IO remote terminal 5 includes one or more IO units 53 and a communication coupler 52 used to carry out processes associated with data transmission in field network 22. These units are configured to transmit and receive data to and from one another through an IO remote terminal bus 51.

Servo motor drivers 531 and 532 are connected to computing unit 13 through field network 22 and drive servo motors 41 and 42 in accordance with command values received from computing unit 13. Specifically, servo motor drivers 531 and 532 receive, from PLC 200, command values including a position command value, a speed command value and a torque command value, at constant time intervals, for example, control periods. Computing unit 13 may generate these command values based on detected values 237 and 239 from encoders 236 and 238. In an aspect, servo motors 41 and 42 may be used as motor 155 that drives rotary knife 154.

Computing unit 13 refers to the detected values from the IO devices described earlier and runs a predetermined control program. Thus, computing unit 13 may allow a robot hand 210 to perform handling of a work, for example, picking up, placing and pressing down the work.

Specifically, computing unit 13 generates a control command 211 for the robot arm and a control command 222 for robot hand 210 and outputs these control command signals to robot hand 210 through robot controller 310. Computing unit 13, at the time of generating control command 211, may refer to a value indicative of the status of robot hand 210 in addition to detected values 61 of the IO devices described earlier. The robot arm may include an optional number of servo motors, for example, servo motors 1301 to 1304.

The whole control system 2 may be targeted for simulation by simulation system 500. Otherwise, only a part of configurations included in control system 2 may be targeted for simulation by simulation system 500.

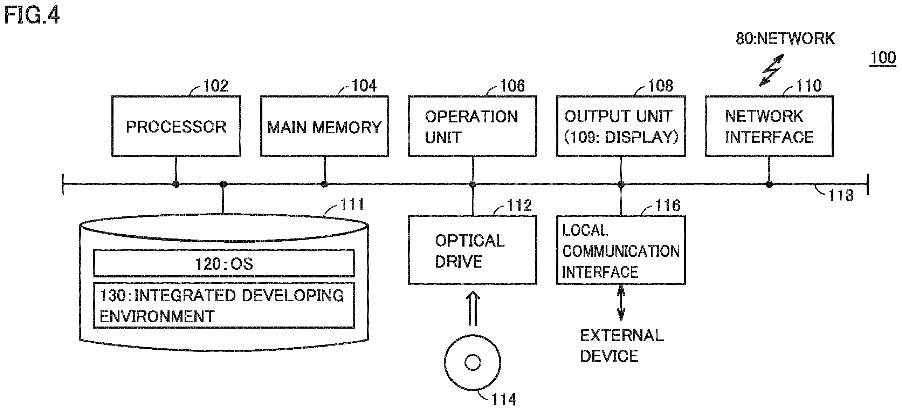

Fig. 4 is a diagram illustrating an example of a hardware configuration of device 100. Device 100 may operate as simulation system 500. In an aspect, simulation system 500 may be a system including a plurality of devices 100 or including at least a part of hardware configurations of device 100. Otherwise, simulation system 500 may be a virtual machine on a cloud platform including at least a part of hardware configurations of device 100.

Device 100 includes, as its principal components, an operating system (OS), a processor 102 that executes a program on the OS, a main memory 104 that provides a working area in which data required for processor 102 to run the program is stored, an operation unit 106 (operation input unit) through which a keyboard and/or a mouse are manipulated by a user, a display 109, indicators, an output unit 108 that outputs a processing result like a printing result, a network interface 110 connected to different networks including network 80, an optical drive 112, a local communication interface 116 that communicates with an external device(s), and a storage 111. These components are interconnected through an internal bus 118 in a manner that they are allowed to communicate data to and from one another.

Device 100 includes optical drive 112. Programs may be read through this optical drive from a computer-readable recording medium 114 and then installed into storage 111. Examples of computer-readable recording medium 114 may include optical recording media in which computer-readable programs are non-transitorily stored (for example, a digital versatile disc (DVD) or the like).

The programs to be executed by device 100 may be installed into device 100 through computer-readable recording medium 114 or may be installed into device 100 through network interface 110 from a server device or the like (not illustrated) on a network.

Storage 111 includes for example, a hard disk drive (HDD) or a flash solid state drive (SSD), and stores a program(s) executed by processor 102. Specifically, storage 111 stores an OS 120 and an integrated developing environment 130. Integrated developing environment 130 may be actualized in the form of an application that operates on OS 120.

Integrated developing environment 130 provides the functional features of simulation system 500 described referring to Fig. 1. In other words, the features of simulation system 500 can be actualized by processor 102 executing integrated developing environment 130 loaded in main memory 104.

In an aspect, the simulation recording feature and debugging feature described referring to Fig. 1 may be actualized as add-in features of integrated developing environment 130.

In an aspect, device 100 may actualize the features of integrated developing environment 130, in whole or in part, using an application specific integrated circuit (ASIC), a field-programmable gate array (FPGA), or the like.

Fig. 5 is a diagram illustrating an example of functional configurations of simulation system 500. The functional configurations illustrated in Fig. 5 may be actualized as program components. In this case, the functional configurations may be allowed to operate, as software, on hardware of device 100.

Simulation system 500 may include, as its functional configurations, a 3D shape displayer 510, a PLC simulator 520, an IEC program editor 530, a variable memory graph displayer 540, a data manager 550, a real device-simulation data comparator 560, and a repository 570.

3D shape displayer 510 renders the simulation in the 3D space on a display. To this end, 3D shape displayer 510 includes a 3D shape reader 511, a 3D shape renderer 512, and a 3D memory displayer 513.

3D shape reader 511 reads a CAD file 580 used in the simulation and converts the read CAD file 580 into a form that can be rendered by 3D shape renderer 512. In an aspect, 3D shape reader 511 may read CAD file 580 from storage 111. In another aspect, 3D shape reader 511 may read CAD file 580 input from outside through network interface 110, optical drive 112, or local communication interface 116.

3D shape renderer 512 displays the object in the 3D space (data obtained from 3D shape reader 511) and the motion of the object on display 109. The object in the 3D space may include a work or the like in addition to the devices included in control system 2. For example, 3D shape renderer 512 exhibits display 260 of the 3D space on display 109.

3D memory displayer 513 displays, on display 109, positional information 252 of the object in the 3D space per execution time. Further, 3D memory displayer 513 reads simulation log 250 from repository 570 and reproduces the simulation recorded in the past. In an aspect, 3D memory displayer 513 may use the rendering feature of 3D shape renderer 512 at the time of reproducing the simulation recorded in the past. In an aspect, 3D memory displayer 513 may render all of the screens illustrated in Figs. 2 and 11 to 14.

PLC simulator 520 executes the program installed in PLC 200 in the ongoing simulation. To this end, PLC simulator 520 includes a step executor 521. In an aspect, PLC simulator 520 may include a display feature used at the time of reproduction of the simulation. In this case, PLC simulator 520 may render all of the screens illustrated in Figs. 2 and 11 to 14.

Step executor 521 executes the program for each step. Step executor 521 may reproduce or reversely reproduce, for each step, simulation log 250 recorded in repository 570. Further, step executor 521 display, on display 109, variable value 254 of the program per execution time. 3D shape displayer 510 may update the display of the object in the 3D space based on the number of times when the program is executed (number of cycles) and a position at which the program is executed (step position) obtained from step executor 521.

IEC program editor 530 receives an operation input for editing of the program through operation unit 106. In an aspect, step executor 521 may carry out the simulation by immediately reflecting any program change by IEC program editor 530.

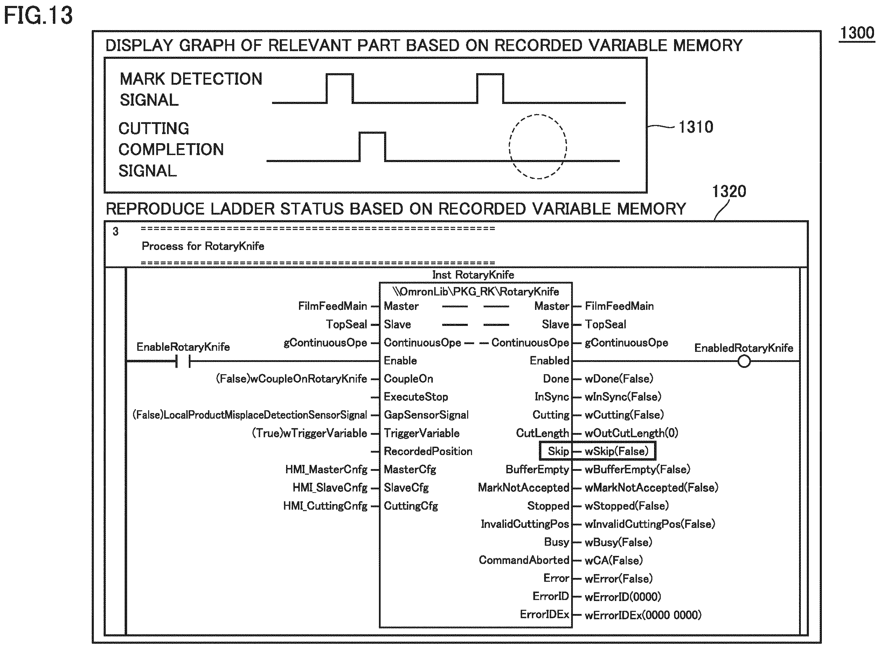

Variable memory graph displayer 540 may display a graph 1310 and the like indicative of changes of the variable value (see Fig. 13) on display 109 based on variable memory 572 recorded in repository 570.

Data manager 550 manages simulation log 250. To this end, data manager 550 includes a data input unit 551, a data reader 552, a data differential extractor 553, and a data differential recorder 554. In an aspect, data manager 550 may acquire recording settings of the simulation through operation unit 106. The recording settings of the simulation include, for example, designating the object(s) to be recorded, designating the variable(s) to be recorded, and designating the duration of the simulation being executed. Data manager 550 may record simulation log 250 based on the obtained settings. In an aspect, the duration of the simulation being executed may be set based on the starting time and ending time of the simulation. In another aspect, the duration of the simulation being executed may be set based on the numbers of steps and of cycles of the program when the program starts and the numbers of steps and of cycles of the program when the program ends.

Data input unit 551 acquires, from 3D shape displayer 510, positional information 252 of the object in the 3D space per execution time. Data reader 552 acquires, from PLC simulator 520, variable value 254 of the program per execution time.

Data reader 552 transmits data stored in a 3D simulation memory 571 to 3D shape displayer 510 at the time of debugging (when the recorded simulation is reproduced). Similarly, data reader 552 transmits data stored in variable memory 572 to PLC simulator 520 at the time of debugging.

Data differential extractor 553 extracts a differential per execution time of data acquired by data input unit 551 (positional information 252 of the object in the 3D space and variable value 254 of the program). Specifically, data differential extractor 553 compares positional information 252 of the object in the 3D space at the first execution time against positional information 252 of the object in the 3D space at the second execution time to extract a differential between these pieces of positional information of the object. Similarly, data differential extractor 553 compares variable value 254 of the program at the first execution time against variable value 254 of the program at the second execution time to extract a differential between these variable values.

Data differential recorder 554 stores, as part of simulation log 250, the extracted differential between the positions of the object in 3D simulation memory 571. Data differential recorder 554 stores, as part of simulation log 250, the extracted differential between the variable values in variable memory 572.

If pieces of positional information 252 of the object in all of the 3D spaces and all of the program variable values 254 are stored in repository 570 for each step, simulation log 250 may certainly contain an enormous volume of data. Therefore, data differential extractor 553 and data differential recorder 554 store only a differential to the previous record in repository 570 and thereby save the memory capacity of repository 570.

Real device-simulation data comparator 560 compares the results of program execution in the simulation and in a real environment. To this end, real device-simulation data comparator 560 includes a synchronizer 561, a data comparator 562, and a displayer 563.

In an aspect, based on a signal or the like obtained from a camera-captured image or a sensor, PLC simulator 520 may output, to data manager 550, a time stamp, positional information of the object per execution time, and variable value of the program in the real environment in a manner that these pieces of information are associated with one another. Real device-simulation data comparator 560 reproduces simulation log 250 stored in repository 570 and a log in the real environment (not illustrated) and may thereby compare the results of program execution in the simulation and in the real environment.

Synchronizer 561 makes cycles in the simulation and in the real environment coincide with each other. Specifically, synchronizer 561 associates the execution time in the simulation (cycles and steps) with the execution time in the real environment (times stamp or steps and cycles of the program in the real environment).

Data comparator 562 compares the results of program execution in the simulation and in the real environment at the same execution time.

Displayer 563 displays the results of program execution in the simulation and in the real environment at the same execution time. According to the invention, displayer 563 displays on display 109, a differential between the results of program execution in the simulation and in the real environment. In another aspect, displayer 563 may highlight and display a differential between the results of program execution in the simulation and in the real environment. This may help a user to easily correct the program in accordance with the real environment.

Repository 570 records simulation log 250. Repository 570 includes 3D simulation memory 571 and variable memory 572. In an aspect, repository 570 may be a repository of a version management system.

3D simulation memory 571 stores, for each step, positional information 252 of the object in the 3D space associated with the execution time.

Variable memory 572 stores, for each step, variable value 254 of the program associated with the execution time.

Repository 570 records an execution log of the program in the real environment. In this case, repository 570 stores, for each step, the positional information of the object in the real environment associated with the execution time in the real environment. Likewise, repository 570 stores, for each step, the variable value of the program in the real environment associated with the execution time in the real environment.

### <C. Steps of recording simulation log>

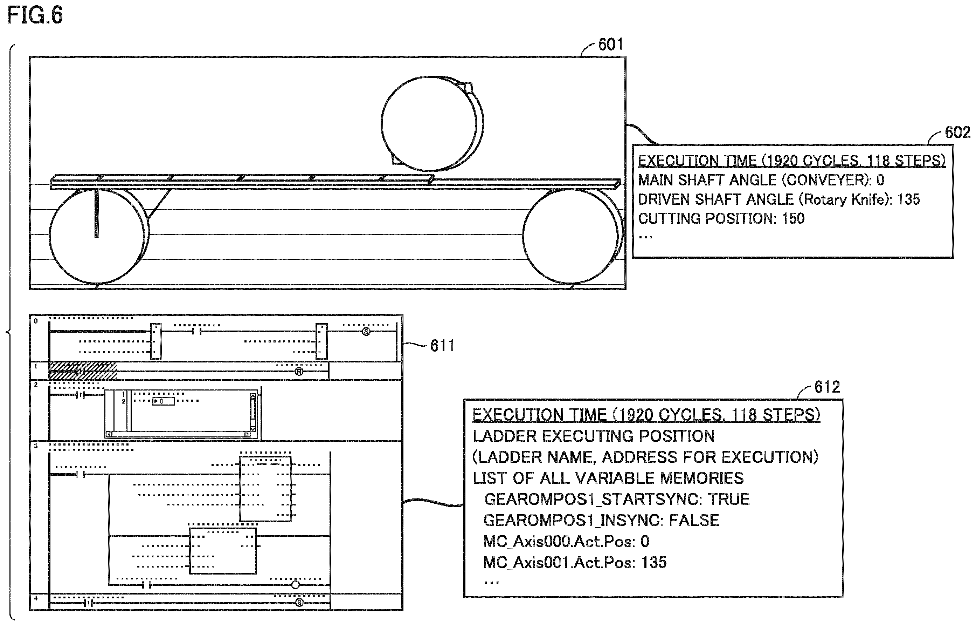

Next, referring to Figs. 6 to 10, steps of recording simulation log 250 by simulation system 500 are described. In the examples illustrated in Figs. 6 to 10, simulation system 500 records simulation log 250 of device 150.

Fig. 6 is a diagram illustrating a first example of ongoing simulation. In the example illustrated in Fig. 6, simulation system 500 is executing a program 611 in the simulation. The motion and the position of each object are reproduced in a 3D space 601.

3D space 601 includes the objects in the 3D space at an execution time (1920 cycles, 118 steps). The execution time (1920 cycles, 118 steps) may be rephrased as a point in time when PLC 200 completed the execution of program 611 1920 times and PLC 200 completed the execution of 118 steps of program 611.

Simulation system 500 stores, in repository 570, the positional information of the object in 3D space 601 and the variable value of the program at each execution time as simulation log 250 every time when PLC 200 executes program 611 for one step in the simulation. Specifically, simulation system 500 stores, in repository 570, differential information indicative of any differential to the previous record.

In the example illustrated in Fig. 6, simulation system 500 stores, in repository 570, positional information 602 of the object in the 3D space and a variable value 612 of the program at an execution time (1920 cycles, 118 steps) as simulation log 250.

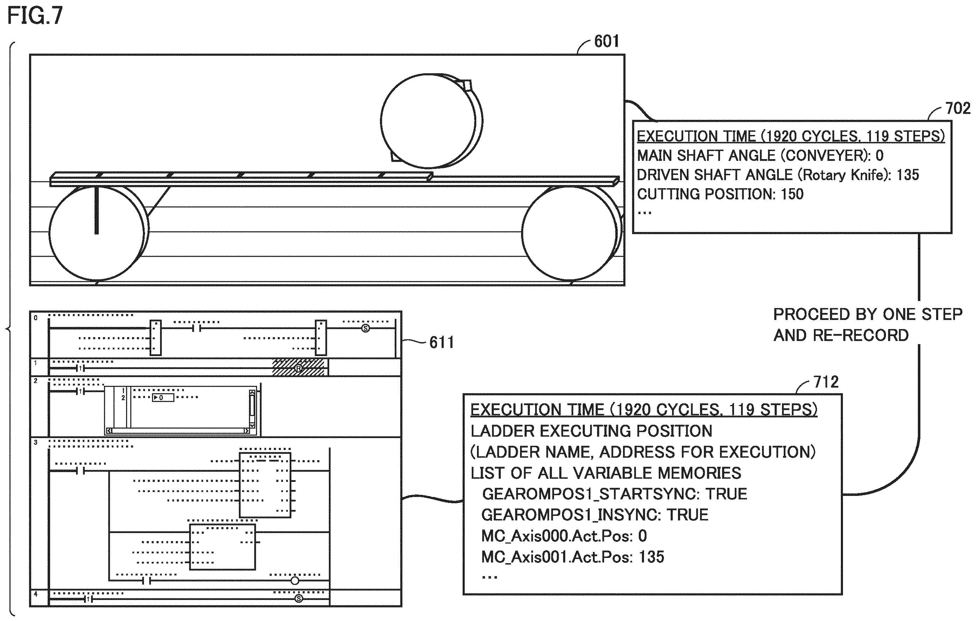

Fig. 7 is a diagram illustrating a second example of ongoing simulation. The example illustrated in Fig. 7 indicates that the execution of program 611 has proceeded by one step from the example illustrated in Fig. 6. 3D space 601 includes the objects in the 3D space at an execution time (1920 cycles, 119 steps).

Since PLC 200 has executed program 611 by one step in the simulation, simulation system 500 stores, in repository 570, positional information 702 of the object in the 3D space and a variable value 712 of the program at the execution time (1920 cycles, 119 steps) as simulation log 250.

At the time, "GEAROMPOS1_INSYNC" is the only difference between positional information 602 of the object in the 3D space and variable value 612 of the program at the execution time (1920 cycles, 118 steps) and positional information 702 of the object in the 3D space and variable value 712 of the program at the execution time (1920 cycles, 119 steps). In this case, simulation system 500 stores the differential value, "GEAROMPOS1_INSYNC" in repository 570 as simulation log 250. Thus, simulation system 500 may save the memory capacity of repository 570 by storing, in this repository, the differential to previously recorded simulation log 250.

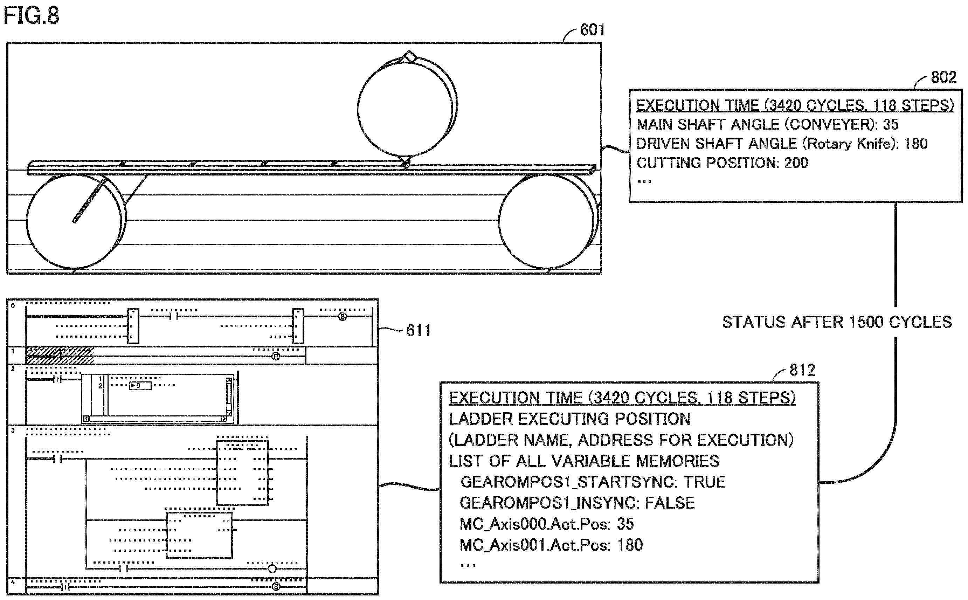

Fig. 8 is a diagram illustrating a third example of ongoing simulation. The example illustrated in Fig. 8 indicates that the execution of program 611 has proceeded by 1500 cycles from the example illustrated in Fig. 6. 3D space 601 includes the objects in the 3D space at an execution time (3420 cycles, 118 steps).

Simulation system 500 continues to store simulation log 250 in repository 570 every time when PLC 200 executes program 611 for one step in the simulation. At the time, simulation system 500 stores, in repository 570, only the differential to previously recorded simulation log 250.

At a point in time illustrated in Fig. 8, positional information 802 of the object in the 3D space and a variable value 812 of the program at an execution time further ahead by 1500 cycles (3420 cycles, 118 steps) from a point in time illustrated in Fig. 6 are stored in repository 570 as simulation log 250.

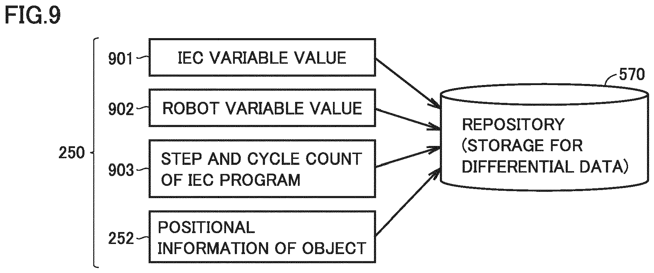

Fig. 9 is a diagram illustrating a first example of data stored in repository 570. In the example illustrated in Fig. 9, simulation log 250 is stored in repository 570. Simulation log 250 includes an IEC variable value 901, a robot variable value 902, a step and cycle count 903 of the IEC program, and positional information 252 of the object in the 3D space.

IEC variable value 901 and robot variable value 902 are included in variable value 254 of the program. IEC variable value 901 includes one or more variable values referred to by the program executed by PLC 200. Robot variable value 902 includes a variable(s) and the like for control of robot hand 210.

Step and cycle count 903 of the IEC program includes the number of times when the program is repeatedly executed (cycles) and a step previously executed. Step and cycle count 903 of the IEC program is associated with positional information 252 of the object in the 3D space and variable value 254 of the program as the simulation execution time.

IEC variable value 901, robot variable value 902, step and cycle count 903 of the IEC program, and positional information 252 of the object are stored in repository 570 for each step as differential information relative to simulation log 250.

In an aspect, it is unnecessary for simulation system 500 to store current simulation log 250 in repository 570 in the case of no differential between current simulation log 250 and simulation log 250 previously stored in repository 570. In another aspect, in the case of no differential between current simulation log 250 and simulation log 250 previously stored in repository 570, simulation system 500 may store step and cycle count 903 of the IEC program in repository 570 instead of storing in repository 570, IEC variable value 901, robot variable value 902, and positional information 252 of the object in the 3D space.

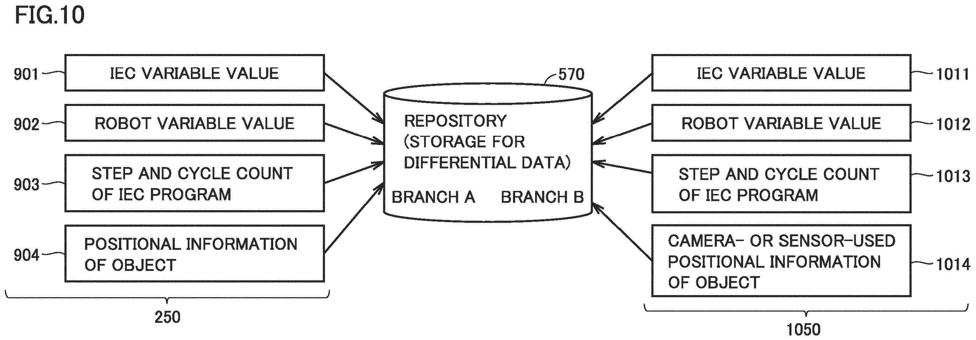

Fig. 10 is a diagram illustrating a second example of data stored in repository 570. In the example illustrated in Fig. 10, simulation log 250 of the program and a log 1050 of the program in the real environment are stored in repository 570.

Log 1050 in the real environment includes an IEC variable value 1011 in the real environment, a robot variable value 1012 in the real environment, a step and cycle count 1013 of the IEC program in the real environment, and positional information 1014 of the object in the real environment.

IEC variable value 1011 in the real environment includes one or more variable values referred to by the program executed by PLC 200 in the real environment.

Robot variable value 1012 in the real environment includes a variable and the like for control of robot hand 210 when the program is executed in the real environment.

Step and cycle count 1013 of the IEC program in the real environment indicates an execution time when the program is executed in the real environment. In an aspect, step and cycle count 1013 of the IEC program in the real environment may include a time stamp calculated from, an execution cycle or the like of the program by PLC 200. In another aspect, simulation system 500 may determine that a point in time when the operation of the device or work is detected by any sensor is the first step of the program in the real environment. Simulation system 500 can synchronize the execution timing of the program in the simulation with the execution timing of the program in the real environment by associating the first step of the program in the real environment with the first step of the program in the simulation.

Positional information 1014 of the object in the real environment indicates the position of the object when the program is executed in the real environment. In an aspect, positional information 1014 of the object in the real environment may be detected with use of a camera (or a 3D camera), a sensor, and the like. Simulation log 250 and log 1050 in the real environment are referred to by real device-simulation data comparator 560. Real device-simulation data comparator 560 may compare the execution results of the program in the simulation and in the real environment by referring to simulation log 250 and log 1050 in the real environment.

In an aspect, simulation system 500 may generate a plurality of branches using a version management system and store simulation log 250 and log 1050 in the real environment in each of the branches.

### <D. Program debugging steps>

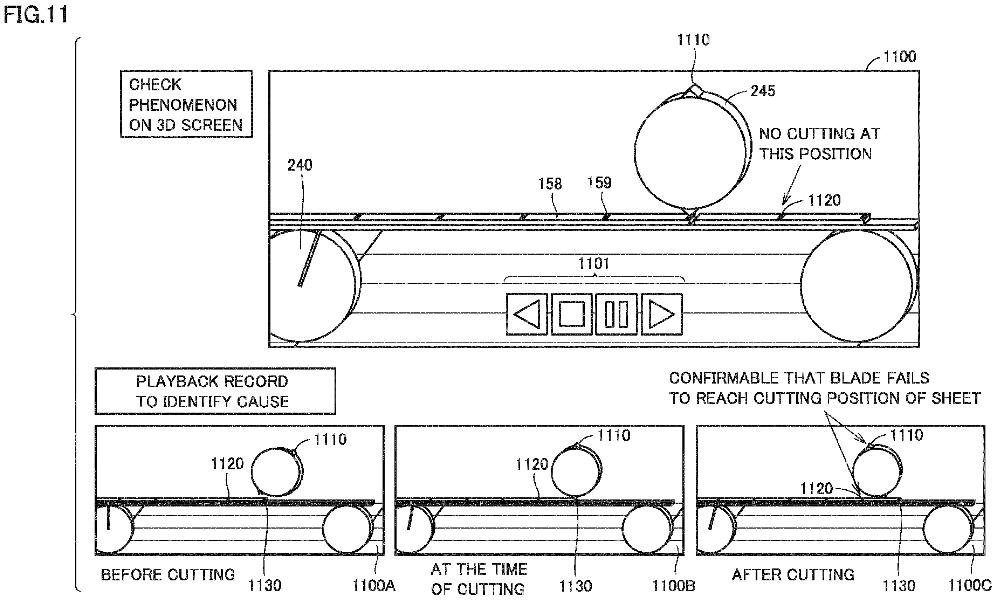

Next, referring to Figs. 11 to 14, steps of debugging the program using simulation system 500 are described. In the examples illustrated in Figs. 11 to 14, simulation system 500 reproduces, for each step, simulation log 250 of device 150 recorded in the past.

Fig. 11 is a diagram illustrating a first example of a debug screen in simulation system 500. A screen 1100 includes a simulation scene reproduced based on simulation log 250 of device 150 recorded in the past. Screen 1100 is displayed on display 109. Screen 1100 may include an operational UI 1101 used to input optional operations, for example, reproduction, reverse reproduction and pausing of the simulation scene for each step, and stoppage of the simulation. This may allow a user to update the simulation scene for each step by manipulating operational UI 1101.

Sheet 158 uncut at a cutting position 1120 is displayed on screen 1100. In this case, a user may look into what is causing any trouble of the program by reproducing the simulation scene after tracking the simulation scene back to a point little earlier using operational UI 1101 (for example, around a point in time when sheet 158 is cut at a cutting position 1130 previous to cutting position 1120).

For example, a screen 1100A displays a scene before sheet 158 is cut at cutting position 1130. A screen 1100B displays a scene when sheet 158 is cut at cutting position 1130. A screen 1100C displays a scene after sheet 158 is cut at cutting position 1130. It is known from screens 1100A to 1100C that a blade 1110 fails to reach cutting position 1120 of sheet 158 after sheet 158 is cut at cutting position 1130. In other words, it is known that the rotating speed of driven shaft 245 is behind the speed at which sheet 158 is carried forward. In an aspect, simulation system 500 may display successive simulation scenes, like screens 1100A to 1100C at the same time on display 109.

Thus, a user may easily grasp a problem or the like in the layout and operations of the devices by reproducing or reversely reproducing the simulation screen for each step and correct the program based on the grasped problem.

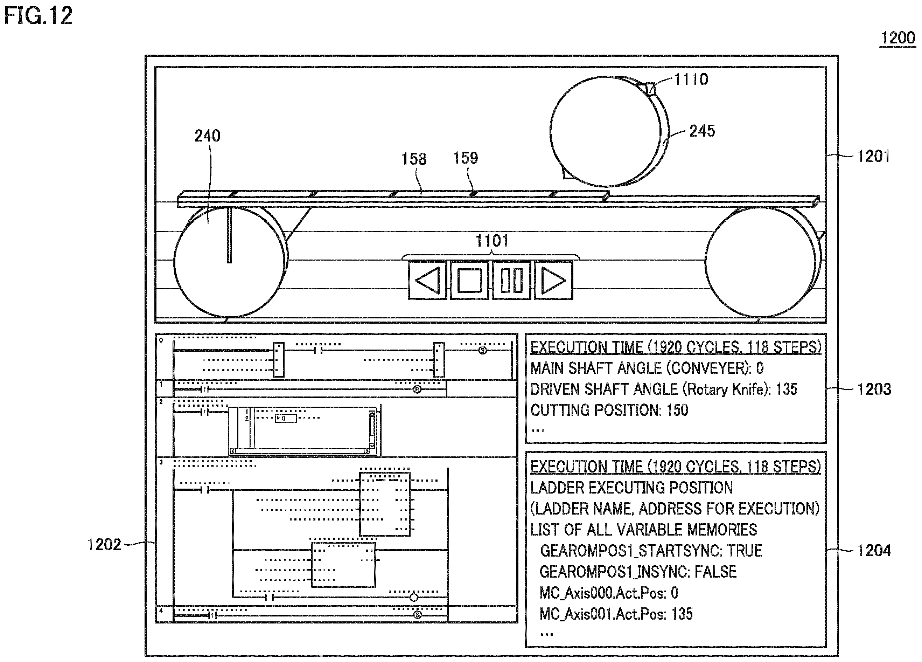

Fig. 12 is a diagram illustrating a second example of the debug screen in simulation system 500. A screen 1200 includes a simulation scene 1201 reproduced based on simulation log 250 of device 150 recorded in the past (display of the 3D space), a program 1202, positional information 1203 of the object, and a variable value 1204 of the program. In an aspect, simulation system 500 (or PLC simulator 520) may receive an operation input for selection of a variable to be traced. Based on the received operation input for selection of the variable to be traced, simulation system 500 (or PLC simulator 520) may include only the value of variable to be traced into variable value 1204 of the program.

A user may update simulation scene 1201 for each step by manipulating operational UI 1101 to reproduce or reversely reproduce the simulation screen. Every time when simulation scene 1201 is updated for each step, program 1202, positional information 1203 of the object, and variable value 1204 of the program are updated likewise.

For example, when a user finds a problem in simulation scene 1201, the user may check simulation scene 1201 for a few steps before and after the problematic scene by manipulating operational UI 1101. The user may further easily grasp a problem of the program by checking program 1202, positional information 1203 of the object, and variable value 1204 of the program for a few steps before and after the problematic scene at the same time.

The user may easily debug the program by checking at least simulation scene 1201 and variable value 1204 of the program. Specifically, when the user finds an abnormality in simulation scene 1201 (3D space), the user can identify the variable value causing such an abnormality in the 3D space by checking variable value 1204 of the program.

The user may debug the program in more detail by checking positional information 1203 of the object containing value-related information, in addition to simulation scene 1201 and variable value 1204 of the program. In the example illustrated in Fig. 12, main shaft 240 and driven shaft 245 need to rotate with the timings of their rotations coordinated with each other in order to cut sheet 158 at cutting position 159. Supposing there is a lag between the timings of rotations of main shaft 240 and driven shaft 245, the user can grasp the specific amount of the lag between the rotation timings by checking positional information 1203 of the object. The user may correct the program (value assigned to the variable or the like) based on the amount of the lag between the rotation timings.

The user may debug the program in more detail by checking program 1202, in addition to simulation scene 1201 and variable value 1204 of the program or in addition to simulation scene 1201, positional information 1203 of the object, and variable value 1204 of the program. Specifically, when the user finds an abnormality in simulation scene 1201 (3D space), the user may grasp a variable value and program code causing a problem by checking variable value 1204 of the program and program 1202 (source code).

As described earlier, operational UI 1101 may receive the following operation inputs; reproduction, reverse reproduction and pausing of the simulation for each step and stoppage of the simulation. In an aspect, operational UI 1101 may receive reproduction and reverse reproduction per cycle (or step), setting of a breakpoint, slow reproduction, and slow reverse reproduction.

It is assumed that a user inputs the operation for reproduction of the simulation through operational UI 1101. In this case, simulation scene 1201 is updated (reproduced) for each step of the program. Further, positional information 1203 of the object and variable value 1204 of the program are updated likewise for each step of the program (updated to values in the next step). This may allow the user to grasp exactly the timing of occurrence of a problem in simulation scene 1201. This may further allow the user to grasp precisely the position of each object by checking positional information 1203 of the object at the timing of occurrence of the problem. Also, the user may identify what is causing malfunction of the program by checking variable value 1204 of the program at the timing of occurrence of the problem.

It is assumed that a user inputs the operation for reverse reproduction of the simulation through operational UI 1101. In this case, simulation scene 1201 is updated (reversely reproduced) for each step of the program. Further, positional information 1203 of the object and variable value 1204 of the program are updated likewise for each step of the program (updated to values in the previous step). This may allow the user to identify what is causing the problem retroactive to a time of occurrence of the problem in simulation scene 1201.

In an aspect, when a user inputs the operation for reproduction or reverse reproduction of the simulation through operational UI 1101 (for example, when a reproduction button (reverse reproduction button) is pressed once), simulation scene 1201, positional information 1203 of the object, and variable value 1204 of the program may be uninterruptedly reproduced (or reversely reproduced) for each step.

In another aspect, when a user inputs the operation for reproduction of or reverse reproduction of the simulation through operational UI 1101 (for example, when the reproduction button (reverse reproduction button) is pressed once), simulation scene 1201, positional information 1203 of the object, and variable value 1204 of the program may be reproduced (or reversely reproduced) for only one step.

It is assumed that a user inputs the operation for pausing (or stoppage) of the simulation through operational UI 1101. In this case, simulation scene 1201, positional information 1203 of the object, and variable value 1204 of the program are paused (or stopped) in an ongoing step of the program. This may allow the user to closely check the position and variable value of each object in an optional step.

It is assumed that a user inputs the operation for frame-by-frame reproduction or reverse reproduction of the simulation through operational UI 1101. In this case, simulation scene 1201, positional information 1203 of the object, and variable value 1204 of the program are reproduced in slow motion for each step of the program. This may allow the user to closely follow and check any change occurred in the position and variable value of each object every time when the program proceeds to a subsequent step.

It is assumed that a user inputs the operation for reproduction of the simulation for one cycle (or one step) through operational UI 1101. In this case, simulation scene 1201, positional information 1203 of the object, and variable value 1204 of the program are reproduced for only one cycle (or one step). This one cycle (or one step) reproduction may allow the user to closely follow and check changes occurred in the position and variable value of each object while reproducing the simulation.

It is assumed that a user inputs the operation for reverse reproduction of the simulation for one cycle (or one step) through operational UI 1101. In this case, simulation scene 1201, positional information 1203 of the object, and variable value 1204 of the program are reversely reproduced for only one cycle (or one step). This reverse reproduction for one cycle (or one step) may allow the user to closely follow and check changes occurred in the position and variable value of each object while reversely reproducing the simulation.

It is assumed that a user inputs the operations for setting of a breakpoint in the program and for reproduction of the simulation through operational UI 1101. In this case, simulation scene 1201, positional information 1203 of the object, and variable value 1204 of the program continue to be reproduced and then paused in a step of the program in which the breakpoint has been set. In an aspect, the breakpoint setting feature may be included in the display of program 1202, 1320 or 1410.

It is assumed that a user inputs the operation for slow reproduction of the simulation through operational UI 1101. In this case, simulation scene 1201, positional information 1203 of the object, and variable value 1204 of the program are reproduced in slow motion. In an aspect, a user may input an operation for setting of a slow reproduction speed through operational UI 1101.

It is assumed that a user inputs the operation for slow reverse reproduction of the simulation through operational UI 1101. In this case, simulation scene 1201, positional information 1203 of the object, and variable value 1204 of the program are reversely reproduced in slow motion. In an aspect, a user may input an operation for setting of a slow reverse reproduction speed through operational UI 1101.

In an aspect, in the case of any change in positional information 1203 of the object and variable value 1204 of the program when simulation scene 1201 is changed (simulation changed to reproduction, reverse reproduction or frame-by-frame reproduction), simulation system 500 may highlight and display a changed value (of the object position or variable).

Fig. 13 is a diagram illustrating a third example of the debug screen in simulation system 500. A screen 1300 includes variable graph 1310 generated based on variable value 254 of the program recorded in the past and program 1320 whose status is reproduced based on variable value 254 of the program recorded in the past.

In an aspect, variable graph 1310 and program 1320 may be displayed with all or part of simulation scene 1201, positional information 1203 of the object, and variable value 1204 of the program.

Simulation system 500 may update each variable value displayed on program 1320 for each step. In an aspect, simulation system 500 may update variable graph 1310 and program 1320 based on the operation input from a user for step reproduction or reverse reproduction or for update of the simulation scene. For example, simulation system 500 may reproduce the program operation per execution time by assigning a variable(s) to the program.

A user can easily grasp a problem of the program by checking the timing of change of each variable value and change in the program status (program operation) at the same time.

In the example illustrated in Fig. 13, a value per execution time is assigned to each variable of program 1320. Supposing that the execution time is "1920 cycles, 118 steps", a value at a point in time at which the program has been executed for 1920 cycles and a process of the 118th step has been executed is assigned to each variable of program 1320.

The value assigned to each variable of program 1320 is updated for each step. For example, when simulation scene 1201 is updated for one step, the value assigned to each variable of program 1320 is also updated for one step.

In an aspect, in the case of any change in the value assigned to each variable of program 1320, simulation system 500 may highlight and display a changed value or a variable name to which the changed value is assigned or may highlight and display both of the changed value and the variable name.

In another aspect, when any variable is selected from one or more variables included in program 1320, simulation system 500 may generate variable graph 1310 including the selected variable.

In yet another aspect, simulation system 500 may highlight and display any graphically illustrated variable in program 1320. In the example illustrated in Fig. 13, simulation system 500 may highlight and display, in program 1320, variables corresponding to a "mark detection signal" and a "cutting completion signal" in variable graph 1310.

This may allow a user to visually recognize any variable change referring to variable graph 1310. Further, the user may accurately grasp the amount of change in the variable value by referring to a highlighted and displayed variable value (changed value) in program 1320.

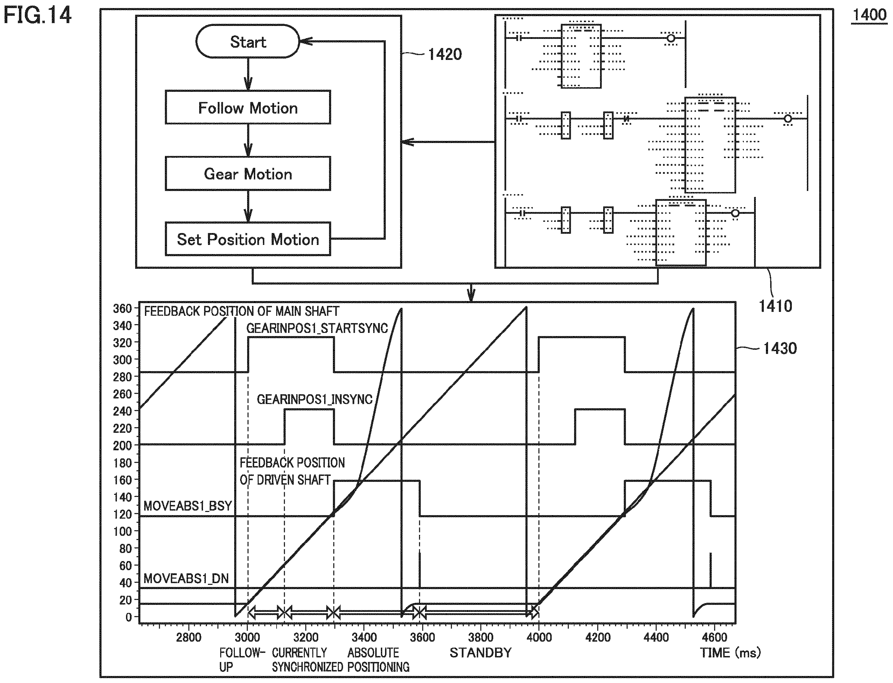

Fig. 14 is a diagram illustrating a fourth example of the debug screen in simulation system 500. A screen 1400 includes a program 1410, a program flowchart 1420, and a variable graph 1430 generated based on variable value 254 of the program recorded in the past. In program 1410, a value may be assigned to each variable per step similarly to program 1320.

In an aspect, program 1410, program flowchart 1420, and variable graph 1430 may be displayed with all or part of simulation scene 1201, positional information 1203 of the object, and variable value 1204 of the program.

Simulation system 500 may update each variable value displayed on program 1410 based on the operation input from a user for step reproduction or reverse reproduction or for update of the simulation scene. Simulation system 500 may highlight and display a process(s) in flowchart 1420 based on the operation input from a user for step reproduction or reverse reproduction or for update of the simulation scene. Simulation system 500 may update variable graph 1430 based on the operation input from a user for step reproduction or reverse reproduction or for update of the simulation scene.

Thus, a user can easily grasp a problem of the program by checking the timing of change of each variable value, change in the program status (program operation), and a process on the flowchart currently executed at the same time.

The blocks in flowchart 1420 may be, for example, associated with POUs of program 1410. In an aspect, simulation system 500 may generate flowchart 1420 from program 1410. In another aspect, simulation system 500 may receive, from a user, an operation input for associating the respective blocks of flowchart 1420 with the POUs of program 1410. In yet another aspect, simulation system 500 may highlight and display, on program 1410, the POU corresponding to the block of flowchart 1420 currently executed. In yet another aspect, the blocks of flowchart 1420 may be selectable. Simulation system 500 may display, on program 1410, the POU corresponding to the block selected on flowchart 1420 or may highlight and display, on program 1410, the POU corresponding to the block selected on flowchart 1420.

Program 1410, program flowchart 1420, and variable graph 1430 are updated for each step. For example, every time when the simulation scene proceeds or returns by one step, the display of program 1410, program flowchart 1420, or variable graph 1430 proceed or return likewise by one step.

In an aspect, elements included in the screens illustrated in Figs. 11 to 14 may be optionally combined and displayed on display 109. For example, simulation system 500 may display, on display 109, simulation scene 1201, program 1320 whose status is reproduced based on variable value 254 of the program recorded in the past, flowchart 1420, and variable graph 1430.

### <E. Flowchart>

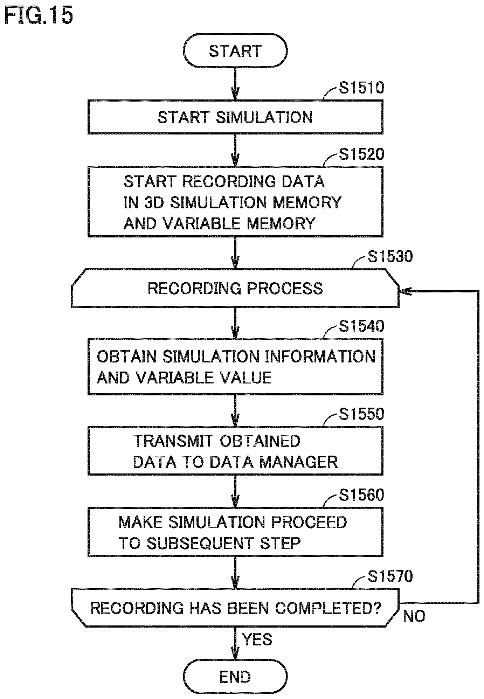

Next, referring to Figs. 15 to 17, simulation result recording process and debugging process by simulation system 500 are described. In an aspect processor 102 may read, from storage 111 into main memory 104, a program for processing steps of Figs. 15 to 17 to be executed (an optional program of integrated developing environment 130) and then execute the program. In another aspect, the processing steps in whole or in part may be actualized in the form of circuit elements combined to execute these steps.

Fig. 15 is a flowchart illustrating an example of a simulation recording process by simulation system 500.

In step S1510, simulation system 500 starts the simulation based on, for example, an operation input from a user for starting the simulation.

In step S1520, simulation system 500 starts to record data in 3D simulation memory 571 and in variable memory 572.

In step S1530, simulation system 500 repeatedly carries out processes in step S1540 and in subsequent steps until the simulation is completed.

In step S1540, simulation system 500 obtains positional information 252 of the object in the 3D space and variable value 254 of the program for each step of the simulation (or of the program).

In step S1550, simulation system 500 transmits the obtained data (simulation log 250, positional information 252 of the object in the 3D space, and variable value 254 of the program) to data manager 550. Data manager 550 commits the obtained data to repository 570.

In step S1560, simulation system 500 makes the simulation (or program) proceed to a subsequent step(s).

In step S1570, simulation system 500 determines whether recording of the simulation is completed. In an aspect, simulation system 500 may determine that recording of the simulation is completed when data for designated cycles is all recorded. In another aspect, simulation system 500 may determine that recording of the simulation is completed when a designated flag is put up (or put down). In yet another aspect, simulation system 500 may determine that recording of the simulation is completed in response to receipt of an operation input for stoppage of the simulation from a user. Simulation system 500 ends the process when it is determined that recording of the simulation is completed (YES in step S1570). Otherwise (NO in step S1570), simulation system 500 makes the process proceed to step S1530. In an aspect, simulation system 500 may carry out the process of step S1570 in step S1530.

In order to record a program execution result in the real environment, simulation system 500 may similarly record the data as described thus far, except for use of camera-captured images, sensor signals, and the like.

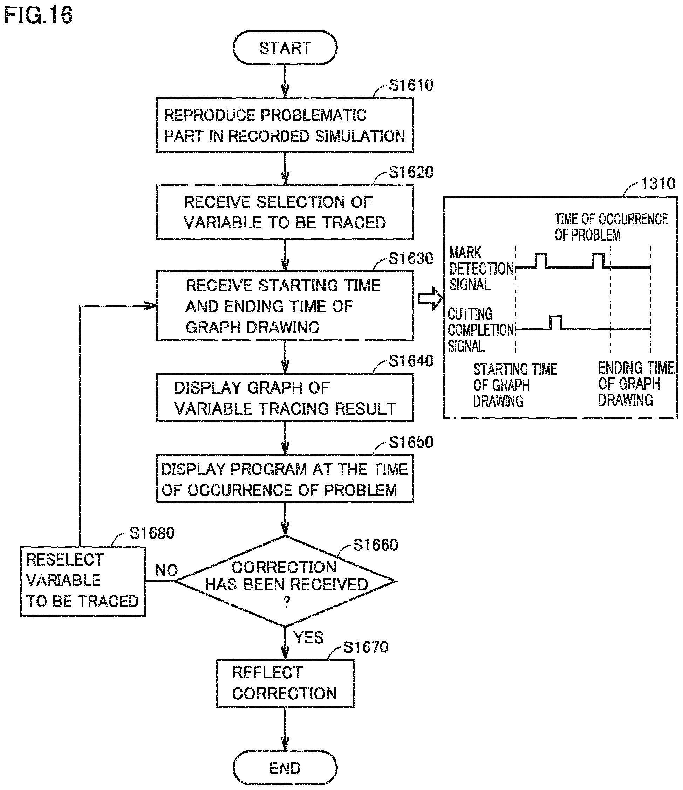

Fig. 16 is a flowchart illustrating an example of the debugging process by simulation system 500.

In step S1610, simulation system 500 reproduces a problematic part in the simulation in response to an operation input from a user.

In step S1620, simulation system 500 receives an operation input for selection of a variable to be traced. In an aspect, PLC simulator 520 or data manager 550 may include a feature that receives an operation input for selection of a variable to be traced.

In step S1630, simulation system 500 receives an operation input for designating a starting time and an ending time of graph drawing. In an aspect, the starting time and ending time of graph drawing may be designated based on the numbers of cycles and steps of the program at the starting time and the numbers of cycles and steps of the program at the ending time. The processes of steps S1620 and S1630 may be carried out prior to step S1610.

In step S1640, simulation system 500 displays, on display 109, a graph showing a variable tracing result (corresponding to graph 1310 indicative of variable value changes). Simulation system 500 may display, on display 109, a graph representing a designated period in response to the input for designating the starting time and ending time of graph drawing in step S1630.

In step S1650, simulation system 500 displays, on display 109, the program when a problem occurs. For example, simulation system 500 may display, on display 109, the program (variable-inputted program) corresponding to an execution time (steps and cycles) of a relevant problematic simulation scene in response to the simulation scene being displayed on display 109 in step S1610.

In step S1660, simulation system 500 determines whether an operation input for request of program correction has been received. When it is determined that the program correction request has been received (YES in step S1660), simulation system 500 makes the process proceed to step S1670. Otherwise (NO in step S1660), simulation system 500 makes the process proceed to step S1680.

In step S1670, simulation system 500 reflects the correction in the program.

In step S1680, simulation system 500 receives an operation input for reselection of the variable to be traced. For example, a user reselects the variable to be traced when the problematic part of the program displayed in step S1650 fails to be identified, so that the user can search the problematic part of the program from a different perspective.

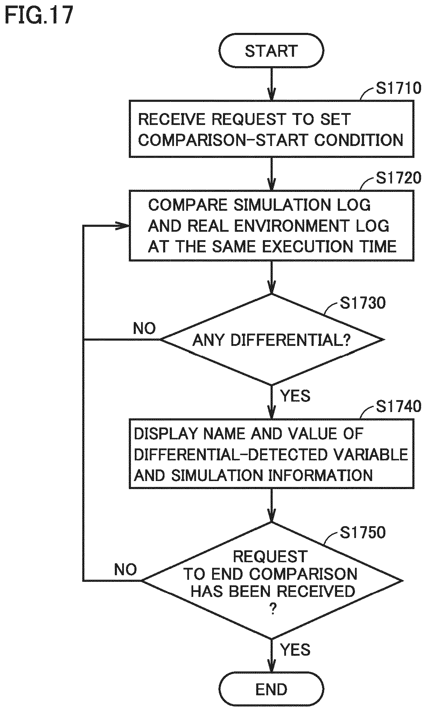

Fig. 17 is a flowchart illustrating an example of a comparison process for between a program simulation result by simulation system 500 and a program execution result in a real environment.

In step S1710, simulation system 500 receives an operation input for condition settings to start the comparison. The comparison-start conditions include conditions under which execution times in the simulation and in the real environment are associated with each other. In an aspect, simulation system 500 may, for example, associate the timing of signal output in response to detection of a work or device operation using a particular sensor in the real environment with the execution time in the simulation (0 cycle, one step).

In step S1720, simulation system 500 compares simulation log 250 and log 1050 in the real environment at the same execution time (with the same number of program cycles and steps). In an aspect, simulation system 500 may compare the variable values or pieces of positional information of the object included in each log or may compare both of these values and information.

In step S1730, simulation system 500 determines whether a differential is found between simulation log 250 and log 1050 in the real environment. When it is determined that the differential is found between simulation log 250 and log 1050 in the real environment (YES in step S1730), simulation system 500 makes the process proceed to step S1740. Otherwise (NO in step S1730), simulation system 500 makes the process proceed to step S1720.

In step S1740, simulation system 500 displays the name and value of a differential-identified variable and simulation information. The simulation information described herein includes a simulation scene(s) in differential-confirmed step. In an aspect, the simulation information may include positional information 252 of the object in the 3D space.

In step S1750, simulation system 500 determines whether a comparison process ending request is received. For example, simulation system 500 may receive the comparison process ending request through operation unit 106 or network interface 110. Simulation system 500 ends the process when it is determined that the comparison process ending request has been received (YES in step S1750). Otherwise (NO in step S1750), simulation system 500 makes the process proceed to

As described thus far, simulation system 500 according to this embodiment includes a feature that records variable value 254 of the program and positional information 252 of the object in the 3D space during the ongoing simulation in a manner that they are associated with each other per execution time. Simulation system 500 further includes a feature that performs per-step reproduction and reverse reproduction of the simulation using positional information 252 of the object in the 3D space and variable value 254 of the program. Simulation system 500 further includes a feature that displays variable value 254 of the program and positional information 252 of the object in the 3D space for each step. These features may allow a user to reproduce the simulation per step and easily identify a simulation scene(s) suggesting trouble with the operation of any device. Then, a user may easily debug the program by referring to variable value 254 of the program in any problematic simulation scene.

Simulation system 500 further includes a feature that compares simulation log 250 and log 1050 in the real environment against each other. This may allow a user to easily grasp a problem of the program in the real environment or a problem of the layout of devices.

Although the present invention has been described and illustrated in detail, it is clearly understood that the same is by way of illustration and example only and is not to be taken by way of limitation, the scope of the present invention being interpreted by the terms of the appended claims.

## Claims

1. A simulation system (500), comprising:
a memory (111) configured to store a program to control one or more devices;
a processor (102) configured to execute a simulation of an operation of the one or more devices enabled by the program; and
a display (109) configured to display a simulation screen,
wherein the simulation screen includes
a display of a three-dimensional, 3D, space (1201) for display of a position of the one or more devices in the 3D space (1201), and
a display of a value of one or more variables (1204) referred to by the program,
wherein the simulation screen is configured to update, for each step of the program, the display of the 3D space (1201) and the display of the value of the one or more variables (1204),
**characterized in that**:
the simulation system is configured to record in a repository (570) an execution log of the program in a real environment, wherein the execution log of the program in the real environment includes, for each step of the program, positional information of the one or more devices in the real environment associated with an execution time in the real environment, and a variable value of the program in the real environment associated with the execution time in the real environment;
the simulation system is further configured to record in the repository a simulation log (250), wherein the simulation log includes, for each step of the program, positional information (252) of the one or more devices in the 3D space associated with an execution time in the simulation, and a variable value (254) of the program associated with the execution time in the simulation; and
the simulation system further comprises a real device-simulation data comparator (560) configured to compare results of execution of the program in the simulation and execution of the program in the real environment, based on the execution log of the program in the real environment and the simulation log, wherein the real device-simulation data comparator includes:
a synchronizer (561) configured to associate an execution time in the simulation with an execution time in the real environment;
a data comparator (562) configured to compare the results of execution of the program in the simulation and execution of the program in the real environment at the same execution time; and
a displayer (563) configured to display on the display (109) a differential between the results of execution of the program in the simulation and execution of the program in the real environment.

2. The simulation system (500) according to claim 1, wherein the simulation screen further includes a user interface, UI, for input use (1101) configured to receive an operation input for reproduction or reverse reproduction of a simulation scene for each step of the program.

3. The simulation system (500) according to claim 2, wherein the UI for input use (1101) is configured to receive an operation input for stoppage or frame-by-frame reproduction of the simulation scene for each step of the program.

4. The simulation system (500) according to claim 2, wherein the UI for input use (1101) is configured to receive an operation input for reproduction or reverse reproduction of the simulation scene for one cycle or for one step of the program.

5. The simulation system (500) according to claim 2, wherein the simulation screen is configured to receive an operation input for setting a breakpoint in the program.

6. The simulation system (500) according to claim 2, wherein the UI for input use (1101) is configured to receive an operation input for slow reproduction or slow reverse reproduction of the simulation scene.

7. The simulation system (500) according to any one of claims 1 to 6, wherein the simulation screen further includes value-related information (1203) of the position of the one or more devices, and
the simulation screen is configured to update the value-related information (1203) of the position of the one or more devices for each step of the program.

8. The simulation system (500) according to any one of claims 1 to 7, wherein the simulation screen is configured to further display the program,
a display of the program (1320) includes
a code of the program, and
the value of the one or more variables (1204), and
the simulation screen is configured to update the value of the one or more variables (1204) included in the display of the program (1320) for each step of the program.

9. The simulation system (500) according to claim 8, wherein the simulation screen is configured to highlight and display a changed value or a variable name to which the changed value has been assigned in a case of any change of the value of the one or more variables (1204) included in the display of the program (1320) when the step of the program proceeds or returns.

10. The simulation system (500) according to claim 8 or 9, wherein
the display of the program is configured to select the value of one or more variables (1204), and
the simulation screen is configured to display a graph (1310) including the variable selected from the display of the program (1320).

11. The simulation system (500) according to claim 10, wherein the display of the program (1320) is configured to highlight and display the variable included in the graph.

12. The simulation system (500) according to any one of claims 1 to 11, wherein
the simulation screen is configured to further display a flowchart of the program (1320), and
a display of the flowchart is configured to highlight and display a block currently executed among one or more blocks included in the flowchart.

13. The simulation system (500) according to claim 12, wherein
the display of the flowchart is configured to select one of the one or more blocks included in the flowchart, and
the display of the program (1320) is configured to display a program (1320) organization unit, POU, corresponding to the block that has been selected, or to highlight and display the POU.

14. A method executable by a simulation system (500), comprising:
executing a simulation of an operation of one or more devices enabled by a program (1320) to control the one or more devices; and
displaying a simulation screen,
wherein the simulation screen includes
a display of a 3D space (1201) for display of a position of the one or more devices in the 3D space (1201), and
a display a value of one or more variables (1204) referred to by the program (1320),
wherein the simulation screen is configured to update, for each step of the program (1320), the display of the 3D space (1201) and the display of the value of the one or more variables (1204),
**characterized in that**:
the method further comprises recording an execution log of the program in a real environment in a repository (570), wherein the execution log of the program in the real environment includes, for each step of the program, positional information of the one or more devices in the real environment associated with an execution time in the real environment, and a variable value of the program in the real environment associated with the execution time in the real environment;
the method further comprises recording a simulation log (250) in the repository, wherein the simulation log includes, for each step of the program, positional information (252) of the one or more devices in the 3D space associated with an execution time in the simulation, and a variable value (254) of the program associated with the execution time in the simulation; and
the method further comprises comparing results of execution of the program in the simulation and execution of the program in the real environment, based on the execution log of the program in the real environment and the simulation log, by:
associating an execution time in the simulation with an execution time in the real environment;
comparing the results of execution of the program in the simulation and execution of the program in the real environment at the same execution time; and
displaying a differential between the results of execution of the program in the simulation and execution of the program in the real environment.

15. A program executable by a simulation system (500), the program causing the simulation system (500) to:
execute a simulation of an operation of one or more devices by software to control the one or more devices; and
display a simulation screen,
wherein the simulation screen includes
a display of a 3D space (1201) for display of a position of the one or more devices in the 3D space (1201), and
a display of a value of one or more variables (1204) referred to by the software,
wherein the simulation screen is configured to update, for each step of the software, the display of the 3D space (1201) and the display of the value of the one or more variables (1204),
**characterized in that**:
the program further causes the simulation system to record an execution log of the program in a real environment in a repository (570), wherein the execution log of the program in the real environment includes, for each step of the program, positional information of the one or more devices in the real environment associated with an execution time in the real environment, and a variable value of the program in the real environment associated with the execution time in the real environment;
the program further causes the simulation system to record a simulation log (250) in the repository, wherein the simulation log includes, for each step of the program, positional information (252) of the one or more devices in the 3D space associated with an execution time in the simulation, and a variable value (254) of the program associated with the execution time in the simulation; and
the program further causes the simulation system to compare results of execution of the program in the simulation and execution of the program in the real environment, based on the execution log of the program in the real environment and the simulation log, by:
associating an execution time in the simulation with an execution time in the real environment;
comparing the results of execution of the program in the simulation and execution of the program in the real environment at the same execution time; and
displaying a differential between the results of execution of the program in the simulation and execution of the program in the real environment.

## Patentansprüche

1. Simulationssystem (500), umfassend:
einen Speicher (111), der ausgelegt ist, um ein Programm zum Steuern von einer oder mehreren Vorrichtungen zu speichern;
einen Prozessor (102), der ausgelegt ist, um eine Simulation einer Operation der einen oder mehreren Vorrichtungen, die durch das Programm aktiviert wurden, auszuführen; und
eine Anzeige (109), die ausgelegt ist, um einen Simulationsbildschirm anzuzeigen,
wobei der Simulationsbildschirm Folgendes umfasst:
eine Anzeige eines dreidimensionalen, 3D-, Raums (1201) zum Anzeigen einer Position der einen oder mehreren Vorrichtungen im 3D-Raum (1201) und
eine Anzeige eines Werts von einer oder mehreren Variablen (1204), auf die von dem Programm Bezug genommen wird,
wobei der Simulationsbildschirm ausgelegt ist, um für jeden Schritt des Programms die Anzeige des 3D-Raums (1201) und die Anzeige des Werts der einen oder mehreren Variablen (1204) zu aktualisieren,
**dadurch gekennzeichnet, dass**:
das Simulationssystem ausgelegt ist, um in einem Archiv (570) ein Ausführungsprotokoll des Programms in einer realen Umgebung aufzuzeichnen, wobei das Ausführungsprotokoll des Programms in der realen Umgebung für jeden Schritt des Programms Positionsinformationen der einen oder mehreren Vorrichtungen in der realen Umgebung, die einem Ausführungszeitpunkt in der realen Umgebung zugeordnet sind, und einen variablen Wert des Programms in der realen Umgebung, der dem Ausführungszeitpunkt in der realen Umgebung zugeordnet ist, umfasst;
das Simulationssystem ferner ausgelegt ist, um in dem Archiv ein Simulationsprotokoll (250) aufzuzeichnen, wobei das Simulationsprotokoll für jeden Schritt des Programms Positionsinformationen (252) der einen oder mehreren Vorrichtungen im 3D-Raum, die einem Ausführungszeitpunkt in der Simulation zugeordnet sind, und einen variablen Wert (254) des Programms, der dem Ausführungszeitpunkt in der Simulation zugeordnet ist, umfasst; und
das Simulationssystem ferner einen Reale-Vorrichtung-Simulations-Datenvergleichseinheit (560) umfasst, die ausgelegt ist, um Ergebnisse der Ausführung des Programms in der Simulation und Ausführung des Programms in der realen Umgebung beruhend auf dem Ausführungsprotokoll des Programms in der realen Umgebung und dem Simulationsprotokoll zu vergleichen, wobei die Reale-Vorrichtung-Simulations-Datenvergleichseinheit Folgendes umfasst:
eine Synchronisationseinheit (561), die ausgelegt ist, um einen Ausführungszeitpunkt in der Simulation einem Ausführungszeitpunkt in der realen Umgebung zuzuordnen;
einen Datenkomparator (562), der ausgelegt ist, um die Ergebnisse der Ausführung des Programms in der Simulation und der Ausführung des Programms in der realen Umgebung zum selben Ausführungszeitpunkt zu vergleichen; und
eine Anzeigevorrichtung (563), die ausgelegt ist, um einen Unterschied zwischen den Ergebnissen der Ausführung des Programms in der Simulation und der Ausführung des Programms in der realen Umgebung auf der Anzeige (109) anzuzeigen.

2. Simulationssystem (500) nach Anspruch 1, wobei der Simulationsbildschirm ferner eine Benutzeroberfläche, Ul, zum Eingabegebrauch (1101) umfasst, die ausgelegt ist, um eine Betriebseingabe zur Reproduktion oder umgekehrten Reproduktion einer Simulationsszene für jeden Schritt des Programms zu empfangen.

3. Simulationssystem (500) nach Anspruch 2, wobei die UI zum Eingabegebrauch (1101) ausgelegt ist, um eine Betriebseingabe zum Anhalten oder zur Bild-für-Bild-Reproduktion der Simulationsszene für jeden Schritt des Programms zu empfangen.

4. Simulationssystem (500) nach Anspruch 2, wobei die UI zum Eingabegebrauch (1101) ausgelegt ist, um eine Betriebseingabe zur Reproduktion oder umgekehrten Reproduktion der Simulationsszene für einen Zyklus oder für einen Schritt des Programms empfängt.

5. Simulationssystem (500) nach Anspruch 2, wobei der Simulationsbildschirm ausgelegt ist, um eine Betriebseingabe zum Einstellen eines Haltepunkts im Programm zu empfangen.

6. Simulationssystem (500) nach Anspruch 2, wobei die UI zum Eingabegebrauch (1101) ausgelegt ist, um eine Betriebseingabe zur langsamen Reproduktion oder zur langsamen umgekehrten Reproduktion der Simulationsszene zu empfangen.

7. Simulationssystem (500) nach einem der Ansprüche 1 bis 6, wobei
der Simulationsbildschirm ferner wertbezogene Informationen (1203) über die Position der einen oder mehreren Vorrichtungen umfasst und
der Simulationsbildschirm ausgelegt ist, um die wertbezogenen Informationen (1203) der Position der einen oder mehreren Vorrichtungen für jeden Schritt des Programms zu aktualisieren.

8. Simulationssystem (500) nach einem der Ansprüche 1 bis 7, wobei der Simulationsbildschirm ausgelegt ist, um ferner das Programm anzuzeigen,
eine Anzeige des Programms (1320) Folgendes umfasst
einen Code des Programms und
den Wert der einen oder mehreren Variablen (1204) und
der Simulationsbildschirm ausgelegt ist, um den Wert der einen oder mehreren Variablen (1204), der in der Anzeige des Programms (1320) umfasst ist, für jeden Schritt des Programms zu aktualisieren.

9. Simulationssystem (500) nach Anspruch 8, wobei der Simulationsbildschirm ausgelegt ist, um einen veränderten Wert oder einen Variablennamen, dem der veränderte Wert zugewiesen wurde, im Fall einer Veränderung des Werts der einen oder mehreren Variablen (1204), der in der Anzeige des Programms (1320) umfasst ist, hervorzuheben und anzuzeigen, wenn der Schritt des Programms weiterläuft oder wiederkehrt.

10. Simulationssystem (500) nach Anspruch 8 oder 9, wobei
die Anzeige des Programms ausgelegt ist, um den Wert von einer oder mehreren Variablen (1204) auszuwählen, und
der Simulationsbildschirm ausgelegt ist, um einen Graphen (1310) anzuzeigen, der die aus der Anzeige des Programms (1320) ausgewählte Variable umfasst.

11. Simulationssystem (500) nach Anspruch 10, wobei die Anzeige des Programms (1320) ausgelegt ist, um die im Graphen umfasste Variable hervorzuheben und anzuzeigen.

12. Simulationssystem (500) nach einem der Ansprüche 1 bis 11,
wobei
der Simulationsbildschirm ausgelegt ist, um ferner ein Flussdiagramm des Programms (1320) anzuzeigen, und
eine Anzeige des Flussdiagramms ausgelegt ist, um einen Block, der aktuell ausgeführt wird, von einem oder mehreren im Flussdiagramm umfassten Blöcken hervorzuheben und anzuzeigen.

13. Simulationssystem (500) nach Anspruch 12, wobei
die Anzeige des Flussdiagramms ausgelegt ist, um einen aus dem einen oder den mehreren im Flussdiagramm umfassten Blöcke auszuwählen, und
die Anzeige des Programms (1320) ausgelegt ist, um eine Programm- (1320) Organisationseinheit, POU, entsprechend dem ausgewählten Block anzuzeigen oder die POU hervorzuheben und anzuzeigen.

14. Verfahren, das durch ein Simulationssystem (500) ausführbar ist, wobei das Verfahren Folgendes umfasst:
Ausführen einer Simulation einer Operation von einer oder mehreren Vorrichtungen, die durch ein Programm (1320) aktiviert wurden, um die eine oder mehreren Vorrichtungen zu steuern; und
Anzeigen eines Simulationsbildschirms,
wobei der Simulationsbildschirm Folgendes umfasst
eine Anzeige eines 3D-Raums (1201) zum Anzeigen einer Position der einen oder mehreren Vorrichtungen im 3D-Raum (1201) und
eine Anzeige eines Werts von einer oder mehreren Variablen (1204), auf die von dem Programm (1320) Bezug genommen wird,
wobei der Simulationsbildschirm ausgelegt ist, um für jeden Schritt des Programms (1320) die Anzeige des 3D-Raums (1201) und die Anzeige des Werts der einen oder mehreren Variablen (1204) zu aktualisieren,
**dadurch gekennzeichnet, dass**:
das Verfahren ferner das Aufzeichnen eines Ausführungsprotokolls des Programms in einer realen Umgebung in einem Archiv (570) umfasst, wobei das Ausführungsprotokoll des Programms in der realen Umgebung für jeden Schritt des Programms Positionsinformationen der einen oder mehreren Vorrichtungen in der realen Umgebung, die einem Ausführungszeitpunkt in der realen Umgebung zugeordnet sind, und einen variablen Wert des Programms in der realen Umgebung, der dem Ausführungszeitpunkt in der realen Umgebung zugeordnet ist, umfasst;
das Verfahren ferner das Aufzeichnen eines Simulationsprotokolls (250) in dem Archiv umfasst, wobei das Simulationsprotokoll für jeden Schritt des Programms Positionsinformationen (252) der einen oder mehreren Vorrichtungen im 3D-Raum, die einem Ausführungszeitpunkt in der Simulation zugeordnet sind, und einen variablen Wert (254) des Programms, der dem Ausführungszeitpunkt in der Simulation zugeordnet ist, umfasst; und
das Verfahren ferner das Vergleichen von Ergebnissen der Ausführung des Programms in der Simulation und Ausführung des Programms in der realen Umgebung beruhend auf dem Ausführungsprotokoll des Programms in der realen Umgebung und dem Simulationsprotokoll umfasst, und zwar durch:
Zuordnen eines Ausführungszeitpunkts in der Simulation zu einem Ausführungszeitpunkt in der realen Umgebung;
Vergleichen der Ergebnisse der Ausführung des Programms in der Simulation und der Ausführung des Programms in der realen Umgebung zum selben Ausführungszeitpunkt; und
Anzeigen eines Unterschieds zwischen den Ergebnissen der Ausführung des Programms in der Simulation und der Ausführung des Programms in der realen Umgebung.

15. Programm, ausführbar durch ein Simulationssystem (500), wobei das Programm bewirkt, dass das Simulationssystem (500):
eine Simulation einer Operation von einer oder mehreren Vorrichtungen durch eine Software zum Steuern der einen oder mehreren Vorrichtungen ausführt; und
einen Simulationsbildschirm anzeigt,
wobei der Simulationsbildschirm Folgendes umfasst:
eine Anzeige eines 3D-Raums (1201) zum Anzeigen einer Position der einen oder mehreren Vorrichtungen im 3D-Raum (1201) und
eine Anzeige eines Werts von einer oder mehreren Variablen (1204), auf die von dem Programm Bezug genommen wird,
wobei der Simulationsbildschirm ausgelegt ist, um für jeden Schritt der Software die Anzeige des 3D-Raums (1201) und die Anzeige des Werts der einen oder mehreren Variablen (1204) zu aktualisieren,
**dadurch gekennzeichnet, dass**:
das Programm ferner bewirkt, dass das Simulationssystem ein Ausführungsprotokoll des Programms in einer realen Umgebung in einem Archiv (570) aufzeichnet, wobei das Ausführungsprotokoll des Programms in der realen Umgebung für jeden Schritt des Programms Positionsinformationen der einen oder mehreren Vorrichtungen in der realen Umgebung, die einem Ausführungszeitpunkt in der realen Umgebung zugeordnet sind, und einen variablen Wert des Programms in der realen Umgebung, der dem Ausführungszeitpunkt in der realen Umgebung zugeordnet ist, umfasst;
das Programm ferner bewirkt, dass das Simulationssystem ein Simulationsprotokoll (250) in dem Archiv aufzeichnet, wobei das Simulationsprotokoll für jeden Schritt des Programms Positionsinformationen (252) der einen oder mehreren Vorrichtungen im 3D-Raum, die einem Ausführungszeitpunkt in der Simulation zugeordnet sind, und einen variablen Wert (254) des Programms, der dem Ausführungszeitpunkt in der Simulation zugeordnet ist, umfasst; und
das Programm ferner bewirkt, dass das Simulationssystem Ergebnisse der Ausführung des Programms in der Simulation und Ausführung des Programms in der realen Umgebung beruhend auf dem Ausführungsprotokoll des Programms in der realen Umgebung und dem Simulationsprotokoll vergleicht, und zwar durch:
Zuordnen eines Ausführungszeitpunkts in der Simulation zu einem Ausführungszeitpunkt in der realen Umgebung;
Vergleichen der Ergebnisse der Ausführung des Programms in der Simulation und der Ausführung des Programms in der realen Umgebung zum selben Ausführungszeitpunkt; und
Anzeigen eines Unterschieds zwischen den Ergebnissen der Ausführung des Programms in der Simulation und der Ausführung des Programms in der realen Umgebung.

## Revendications

1. Système de simulation (500), comprenant :
une mémoire (111) configurée de manière à stocker un programme pour commander un ou plusieurs dispositifs ;
un processeur (102) configuré de manière à exécuter une simulation d'une opération dudit un ou desdits plusieurs dispositifs permise par le programme ; et
un afficheur (109) configuré de manière à afficher un écran de simulation ;
dans lequel l'écran de simulation inclut :
un afficheur d'un espace tridimensionnel, 3D, (1201) permettant d'afficher une position dudit un ou desdits plusieurs dispositifs dans l'espace 3D (1201) ; et
un afficheur d'une valeur d'une ou plusieurs variables (1204) référencées par le programme ;
dans lequel l'écran de simulation est configuré de manière à mettre à jour, pour chaque étape du programme, l'afficheur de l'espace 3D (1201) et l'afficheur de la valeur de ladite une ou desdites plusieurs variables (1204) ;
**caractérisé en ce que** :
le système de simulation est configuré de manière à enregistrer, dans un référentiel (570), un journal d'exécution du programme dans un environnement réel, dans lequel le journal d'exécution du programme dans l'environnement réel inclut, pour chaque étape du programme, des informations de position dudit un ou desdits plusieurs dispositifs dans l'environnement réel associées à un temps d'exécution dans l'environnement réel, et une valeur de variable du programme dans l'environnement réel associée au temps d'exécution dans l'environnement réel ;
le système de simulation est en outre configuré de manière à enregistrer, dans le référentiel, un journal de simulation (250), dans lequel le journal de simulation inclut, pour chaque étape du programme, des informations de position (252) dudit un ou desdits plusieurs dispositifs dans l'espace 3D associées à un temps d'exécution dans la simulation, et une valeur de variable (254) du programme, associée au temps d'exécution dans la simulation ; et
le système de simulation comprend en outre un comparateur de données de simulation / de dispositif réel (560) configuré de manière à comparer les résultats de l'exécution du programme dans la simulation et de l'exécution du programme dans l'environnement réel, sur la base du journal d'exécution du programme dans l'environnement réel et du journal de simulation, dans lequel le comparateur de données de simulation / de dispositif réel inclut :
un synchroniseur (561) configuré de manière à associer un temps d'exécution dans la simulation à un temps d'exécution dans l'environnement réel ;
un comparateur de données (562) configuré de manière à comparer les résultats de l'exécution du programme dans la simulation et de l'exécution du programme dans l'environnement réel au même temps d'exécution ; et
un dispositif d'affichage (563) configuré de manière à afficher sur l'afficheur (109) un différentiel entre les résultats de l'exécution du programme dans la simulation et l'exécution du programme dans l'environnement réel.

2. Système de simulation (500) selon la revendication 1, dans lequel l'écran de simulation inclut en outre une interface utilisateur, UI, permettant l'utilisation d'entrées (1101) configurée de manière à recevoir une entrée d'opération pour la reproduction ou la reproduction inverse d'une scène de simulation pour chaque étape du programme.

3. Système de simulation (500) selon la revendication 2, dans lequel l'interface UI permettant l'utilisation d'entrées (1101) est configurée de manière à recevoir une entrée d'opération pour un arrêt ou une reproduction trame par trame de la scène de simulation pour chaque étape du programme.

4. Système de simulation (500) selon la revendication 2, dans lequel l'interface UI permettant l'utilisation d'entrées (1101) est configurée de manière à recevoir une entrée d'opération pour une reproduction ou une reproduction inverse de la scène de simulation pour un cycle ou pour une étape du programme.

5. Système de simulation (500) selon la revendication 2, dans lequel l'écran de simulation est configuré de manière à recevoir une entrée d'opération pour définir un point de rupture dans le programme.

6. Système de simulation (500) selon la revendication 2, dans lequel l'interface UI permettant l'utilisation d'entrées (1101) est configurée de manière à recevoir une entrée d'opération pour une reproduction lente ou une reproduction inverse lente de la scène de simulation.

7. Système de simulation (500) selon l'une quelconque des revendications 1 à 6, dans lequel
l'écran de simulation inclut en outre des informations connexes à une valeur (1203) de la position dudit un ou desdits plusieurs dispositifs ; et
l'écran de simulation est configuré de manière à mettre à jour les informations connexes à une valeur (1203) de la position dudit un ou desdits plusieurs dispositifs pour chaque étape du programme.

8. Système de simulation (500) selon l'une quelconque des revendications 1 à 7, dans lequel
l'écran de simulation est configuré de manière à afficher le programme ;
un afficheur du programme (1320) inclut :
un code du programme ; et
la valeur de ladite une ou desdites plusieurs variables (1204) ; et
l'écran de simulation est configuré de manière à mettre à jour la valeur de ladite une ou desdites plusieurs variables (1204) incluses dans l'afficheur du programme (1320) pour chaque étape du programme.

9. Système de simulation (500) selon la revendication 8, dans lequel l'écran de simulation est configuré de manière à mettre en évidence et afficher une valeur modifiée ou un nom de variable auquel la valeur modifiée a été attribuée dans le cas d'une quelconque modification de la valeur de ladite une ou desdites plusieurs variables (1204) incluses dans l'afficheur du programme (1320) lorsque l'étape du programme se poursuit ou revient.

10. Système de simulation (500) selon la revendication 8 ou 9, dans lequel
l'afficheur du programme est configuré de manière à sélectionner la valeur de ladite une ou desdites plusieurs variables (1204) ; et
l'écran de simulation est configuré de manière à afficher un graphe (1310) incluant la variable sélectionnée à partir de l'afficheur du programme (1320).

11. Système de simulation (500) selon la revendication 10, dans lequel l'afficheur du programme (1320) est configuré de manière à mettre en évidence et afficher la variable incluse dans le graphe.

12. Système de simulation (500) selon l'une quelconque des revendications 1 à 11, dans lequel
l'écran de simulation est configuré de manière à afficher en outre un organigramme du programme (1320) ; et
un afficheur de l'organigramme est configuré de manière à mettre en évidence et afficher un bloc actuellement exécuté parmi un ou plusieurs blocs inclus dans l'organigramme.

13. Système de simulation (500) selon la revendication 12, dans lequel
l'afficheur de l'organigramme est configuré de manière à sélectionner un bloc parmi ledit un ou lesdits plusieurs blocs inclus dans l'organigramme ; et
l'afficheur du programme (1320) est configuré de manière à afficher une unité d'organisation de programme (1320), POU, correspondant au bloc qui a été sélectionné, ou à mettre en évidence et afficher l'unité POU.

14. Procédé exécutable par un système de simulation (500), comprenant le fait de :
exécuter une simulation d'une opération dudit un ou desdits plusieurs dispositifs permise par un programme (1320) pour commander ledit un ou lesdits plusieurs dispositifs ; et
afficher un écran de simulation ;
dans lequel l'écran de simulation inclut :
un afficheur d'un espace 3D (1201) permettant d'afficher une position dudit un ou desdits plusieurs dispositifs dans l'espace 3D (1201) ; et
un afficheur d'une valeur d'une ou plusieurs variables (1204) référencées par le programme (1320) ;
dans lequel l'écran de simulation est configuré de manière à mettre à jour, pour chaque étape du programme (1320), l'afficheur de l'espace 3D (1201) et l'afficheur de la valeur de ladite une ou desdites plusieurs variables (1204) ;
**caractérisé en ce que** :
le procédé comprend en outre le fait d'enregistrer un journal d'exécution du programme dans un environnement réel, dans un référentiel (570), dans lequel le journal d'exécution du programme dans l'environnement réel inclut, pour chaque étape du programme, des informations de position dudit un ou desdits plusieurs dispositifs dans l'environnement réel associées à un temps d'exécution dans l'environnement réel, et une valeur de variable du programme dans l'environnement réel associée au temps d'exécution dans l'environnement réel ;
le procédé comprend en outre le fait d'enregistrer un journal de simulation (250), dans le référentiel, dans lequel le journal de simulation inclut, pour chaque étape du programme, des informations de position (252) dudit un ou desdits plusieurs dispositifs dans l'espace 3D associées à un temps d'exécution dans la simulation, et une valeur de variable (254) du programme, associée au temps d'exécution dans la simulation ; et
le procédé comprend en outre le fait de comparer les résultats de l'exécution du programme dans la simulation et de l'exécution du programme dans l'environnement réel, sur la base du journal d'exécution du programme dans l'environnement réel et du journal de simulation :
en associant un temps d'exécution dans la simulation à un temps d'exécution dans l'environnement réel ;
en comparant les résultats de l'exécution du programme dans la simulation et de l'exécution du programme dans l'environnement réel au même temps d'exécution ; et
en affichant un différentiel entre les résultats de l'exécution du programme dans la simulation et l'exécution du programme dans l'environnement réel.

15. Programme exécutable par un système de simulation (500), le programme amenant le système de simulation (500) à :
exécuter une simulation d'une opération dudit un ou desdits plusieurs dispositifs par un logiciel pour commander ledit un ou lesdits plusieurs dispositifs ; et
afficher un écran de simulation ;
dans lequel l'écran de simulation inclut :
un afficheur d'un espace 3D (1201) permettant d'afficher une position dudit un ou desdits plusieurs dispositifs dans l'espace 3D (1201) ; et
un afficheur d'une valeur d'une ou plusieurs variables (1204) référencées par le logiciel ;
dans lequel l'écran de simulation est configuré de manière à mettre à jour, pour chaque étape du logiciel, l'afficheur de l'espace 3D (1201) et l'afficheur de la valeur de ladite une ou desdites plusieurs variables (1204) ;
**caractérisé en ce que** :
le programme amène en outre le système de simulation à enregistrer un journal d'exécution du programme dans un environnement réel, dans un référentiel (570), dans lequel le journal d'exécution du programme dans l'environnement réel inclut, pour chaque étape du programme, des informations de position dudit un ou desdits plusieurs dispositifs dans l'environnement réel associées à un temps d'exécution dans l'environnement réel, et une valeur de variable du programme dans l'environnement réel associée au temps d'exécution dans l'environnement réel ;
le programme amène en outre le système de simulation à enregistrer un journal de simulation (250), dans le référentiel, dans lequel le journal de simulation inclut, pour chaque étape du programme, des informations de position (252) dudit un ou desdits plusieurs dispositifs dans l'espace 3D associées à un temps d'exécution dans la simulation, et une valeur de variable (254) du programme, associée au temps d'exécution dans la simulation ; et
le programme amène en outre le système de simulation à comparer les résultats de l'exécution du programme dans la simulation et de l'exécution du programme dans l'environnement réel, sur la base du journal d'exécution du programme dans l'environnement réel et du journal de simulation :
en associant un temps d'exécution dans la simulation à un temps d'exécution dans l'environnement réel ;
en comparant les résultats de l'exécution du programme dans la simulation et de l'exécution du programme dans l'environnement réel au même temps d'exécution ; et
en affichant un différentiel entre les résultats de l'exécution du programme dans la simulation et l'exécution du programme dans l'environnement réel.
